# EUROPEAN PATENT APPLICATION

(11) **EP 4 749 338 A1**
(43) Date of publication of application: **27.05.2026**
(21) Application number: 25215166.7
(22) Date of filing: 12.11.2025
(51) Int. Cl.: G02B 5/30, G02B 5/22, H10K 50/86, H10K 59/80

(54) **DISPLAY DEVICE INCLUDING OPTICAL CONTROL MODULE AND ELECTRONIC DEVICE INCLUDING THE SAME**

(30) Priority: 26.11.2024 KR 20240170415
(71) Applicant: Samsung Display Co., Ltd., Yongin-si, Gyeonggi-do 17113 (KR)
(72) Inventor: Lee, Heeyoung, 17113 Yongin-si, Gyeonggi-do (KR); An, Sungguk, 17113 Yongin-si, Gyeonggi-do (KR); Ko, Jisun, 17113 Yongin-si, Gyeonggi-do (KR); Kim, Jungwook, 17113 Yongin-si, Gyeonggi-do (KR); Eom, Jimi, 17113 Yongin-si, Gyeonggi-do (KR); Yun, Jooho, 17113 Yongin-si, Gyeonggi-do (KR); Lee, Seungri, 17113 Yongin-si, Gyeonggi-do (KR); Han, Soyeon, 17113 Yongin-si, Gyeonggi-do (KR)
(74) Representative: Gulde & Partner

(57) **Abstract**

A display device (DD) includes a display panel (DP) including a display area (DA), an anti-reflection layer (RPL) disposed on the display panel (DP) and including a plurality of color filters (CF), and an optical control module (OCM). The optical control module (OCM) includes a first film layer (310) including having a first optical axis corresponding to a stretching axis that extends in one a first direction (DR1) and a phase difference layer (320) disposed on the anti-reflection layer (RPL).

## Description

### TECHNICAL FIELD

The present disclosure relates to a display device and, more specifically, to a display device including an optical control module and an electronic device including the same.

### DISCUSSION OF THE RELATED ART

A display device is a component that visually presents information and is typically made up of a substrate divided into two regions: a display area and a non-display area. The display area contains numerous pixel regions, each equipped with thin film transistors (TFTs) and pixel electrodes that are electrically connected. The non-display area houses various conductive lines that deliver electrical signals to the display area.

An organic light-emitting diode (OLED) display device differs from traditional liquid crystal displays (LCDs) in that OLED display devices are able to emit their own light without the need of a separate light source such as a backlight. This allows OLED display devices to be thinner and lighter. In addition, OLED display devices may have various benefits such as lower power consumption, higher luminance, and shorter response times.

Various electronic devices employ display devices to provide visual interfaces that allow users to interact with the system.

### SUMMARY

The invention is defined by the appended set of claims. The description that follows is subjected to this limitation. Any disclosure lying outside the scope of said claims is only intended for illustrative as well as comparative purposes.

A display device includes a display panel including a display area, an anti-reflection layer disposed on the display panel and including a plurality of color filters, and an optical control module. The optical control module includes a first film layer having a first optical axis corresponding to a stretching axis that extends in a first direction and a phase difference layer disposed on the anti-reflection layer.

The phase difference layer may be disposed between the first film layer and the anti-reflection layer. Placing the phase difference layer between the first film layer and the anti-reflection layer enables an effective internal anti-reflection function. In this configuration, the first film layer acts as a linear polarizer for incident and reflected light, while the phase difference layer converts the light to and from a circular polarization state. This arrangement ensures that light reflected from the underlying display panel is blocked by the first film layer, which significantly reduces internal reflectivity and improves screen contrast.

A modulus in the first direction may be greater than a modulus in a second direction orthogonal to the first direction.

A difference between the modulus in the first direction and the modulus in the second direction may be within a range of 0.5 Gpa to 3.0 GPa, inclusive. A modulus difference within the range of 0.5 GPa to 3.0 GPa ensures a particularly effective and efficient creation of the optical axis during the stretching process. Films exhibiting this property achieve a more pronounced polarization effect, leading to a measurable improvement in the reduction of reflectivity compared to films with a smaller modulus difference.

The first film layer may have an average transmittance of visible light of at least 85%. A high average transmittance of at least 85% ensures that the brightness of the light emitted from the display panel is not significantly diminished as it passes through the optical control module. This represents a major advantage over conventional polarizers, which can reduce brightness by 50% or more, and results in improved luminous efficiency, lower power consumption, and potentially longer product life.

The first film layer may lack a visible light absorption axis. By achieving its polarizing function through the physical alignment of polymer chains rather than using iodine or dichroic dyes, the first film layer lacks a light absorption axis. This is the primary reason for the film's high transmittance and allows for maintaining high brightness and power efficiency in the display.

The first film layer may have an elongation ratio within a range of 1.5 times to 3 times, inclusive. An elongation ratio within the specific range of 1.5 to 3 times provides an optimal degree of stretching to uniformly align the polymer chains throughout the first film layer. This controlled alignment creates a well-defined and consistent optical axis across the entire film, which contributes to achieving uniform and effective anti-reflection performance.

The first film layer may include polyethylene terephthalate (PET), polyvinyl alcohol (PVA), polycarbonate (PC), polymethyl methacrylate (PMMA), polystyrene (PS), polypropylene (PP), and/or triacetyl cellulose (TAC). The use of polymer materials such as polyethylene terephthalate, polyvinyl alcohol, or the others listed provides an excellent combination of properties for the first film layer. These materials offer high optical transparency, good mechanical stability for undergoing the uniaxial stretching process, and proven long-term durability, ensuring the reliable optical and physical performance of the optical control module.

The phase difference layer may include a λ/4 phase retardation layer. The use of a λ/4 (quarter-wave) phase retardation layer serves to convert the linearly polarized light from the first film layer into circularly polarized light before it enters the display panel. This conversion is a component of the anti-reflection mechanism, as the handedness of the circularly polarized light is reversed upon reflection, allowing it to be blocked on its return path.

An angle between the first optical axis of the first film layer and a second optical axis of the λ/4 phase retardation layer may be 45 ± 5°. Aligning the optical axis of the λ/4 phase retardation layer at an angle of 45 ± 5° relative to the first film layer's optical axis optimizes the conversion from linear to circular polarization. This specific alignment provides for a highly effective suppression of reflected light, leading to the lowest overall reflectivity and thus the highest image clarity and contrast.

The phase difference layer may further include a λ/2 phase retardation layer. The inclusion of a λ/2 (half-wave) phase retardation layer in combination with the λ/4 layer allows for the creation of a composite retarder with so-called reverse wavelength dispersion. A standard single retarder has a phase delay that varies with wavelength, but this combination can achieve a more uniform phase delay across the entire visible light spectrum, resulting in superior anti-reflection performance for all colors and minimizing chromatic aberrations.

An angle between the second optical axis of the λ/4 phase retardation layer and a third optical axis of the λ/2 phase retardation layer may be 15 ± 5°. The specific angular relationship of 15 ± 5° between the optical axes of the λ/4 and λ/2 phase retardation layers is a design parameter that contributes to achieving the desired reverse wavelength dispersion effect. This precise alignment helps the combined layers function correctly as a single, broadband anti-reflection element across the visible spectrum.

The first film layer may include a first dye configured to selectively absorb light in a first preset wavelength band. By incorporating a first dye into the film layer, it is possible to selectively absorb light in a specific wavelength band. For instance, a blue-light-absorbing dye can be used to counteract any inherent "bluish phenomenon" or color tint in the reflections from the display stack. This results in a more color-neutral appearance, particularly in the display's black state, and improves the overall color fidelity.

The first film layer may further include a second dye configured to selectively absorb light in a second preset wavelength band that is different from the first preset wavelength band. The addition of a second dye that absorbs light in a different wavelength band provides a further degree of freedom for color tuning. This allows for more precise compensation of color shifts in reflections, enabling finer control over the color balance and leading to improved color accuracy and a more faithful image reproduction.

The optical control module may further include a window layer, and the phase difference layer may be disposed under the window layer. The window layer, which may be an ultra-thin glass (UTG) substrate, serves as a durable cover to provide robust physical protection for the entire display module against scratches, impacts, and other environmental factors . Placing the phase difference layer underneath this protective window shields it from external damage, thereby increasing the overall durability and operational lifetime of the device.

The optical control module may further include a second film layer that lacks an optical axis.

The second film layer may be disposed below the first film layer, and the phase difference layer may be disposed below the second film layer. The inclusion of a second, optically isotropic film layer (which lacks an optical axis) can serve as a stable mechanical support or substrate within the optical control module's stack. This allows for more complex manufacturing processes and provides a high-quality surface for depositing other functional layers, such as the phase difference layer, without introducing any unintended polarization effects that could disrupt the anti-reflection function.

The optical control module may further include a surface treatment layer disposed on the first film layer.

The surface treatment layer may include a hard coating layer. The surface treatment layer with a hard coating is disposed on the outermost surface of the display to provide enhanced scratch resistance and physical durability. This protective layer guards the device against damage from daily use, ensuring that the optical quality of the surface is maintained over time.

The surface treatment layer may further include a low refractive index layer and/or a high refractive index layer disposed on the hard coating layer. The addition of low and/or high refractive index layers to the surface treatment layer creates a multi-layer anti-reflection coating that functions based on the principle of optical interference. This structure is specifically designed to minimize reflections occurring at the very front surface of the display (i.e., the air-to-device interface), which complements the device's internal anti-reflection mechanism to achieve superior image clarity, especially in bright ambient lighting conditions.

An electronic device includes an input module configured to receive a command or data. A processor is configured to process the command or data received from the input module and output image data or command data. A display device is configured to implement one or more images by the processor. The display device includes a display panel having a display area, an anti-reflection layer disposed on the display panel and including a plurality of color filters, and an optical control module including a first film layer having a first optical axis that extends along a stretching axis and a phase difference layer disposed on the anti-reflection layer. The display device of the electronic device may be a display device according to any of the above.

The phase difference layer may be disposed between the first film layer and the anti-reflection layer.

The first film layer may have a modulus in a first direction corresponding to the first optical axis and a modulus in a second direction orthogonal to the first direction. The modulus in the first direction may be greater than the modulus in the second direction.

### BRIEF DESCRIPTION OF THE DRAWINGS

A more complete appreciation of the present disclosure and many of the attendant aspects thereof will be readily obtained as the same becomes better understood by reference to the following detailed description when considered in connection with the accompanying drawings, wherein:
FIG. 1 is a perspective view schematically illustrating a display device according to an embodiment;
FIG. 2 is a circuit diagram schematically illustrating a display element provided in one pixel of a display device and a pixel circuit connected thereto, according to an embodiment;
FIG. 3 is a cross-sectional view schematically illustrating a display device according to an embodiment;
FIG. 4 is a cross-sectional view schematically illustrating an electronic panel according to an embodiment;
FIG. 5 is a cross-sectional view schematically illustrating a display module according to an embodiment;
FIG. 6 is a cross-sectional view schematically illustrating an optical control module according to an embodiment;
FIG. 7 is a cross-sectional view schematically illustrating an embodiment of the optical control module of FIG. 6;
FIG. 8 is a cross-sectional view schematically illustrating an embodiment of the optical control module of FIG. 6;
FIG. 9 is a cross-sectional view schematically illustrating an embodiment of the optical control module of FIG. 6;
FIG. 10 is a diagram illustrating a relationship between optical axes in a display device, according to an embodiment;
FIG. 11 is a cross-sectional view schematically illustrating a display device according to an embodiment;
FIG. 12 is a cross-sectional view schematically illustrating a display device according to an embodiment;
FIG. 13 is a cross-sectional view schematically illustrating a display device according to an embodiment;
FIG. 14 is a cross-sectional view schematically illustrating a display device according to an embodiment;
FIG. 15 is a cross-sectional view schematically illustrating a display device according to an embodiment;
FIG. 16 is a block diagram illustrating an electronic device to which a display device according to an embodiment is applied;
FIG. 17 is a perspective view illustrating an electronic device to which a display device according to an embodiment is applied;
FIGS. 18 and 19 are perspective views illustrating an electronic device to which a display device according to an embodiment is applied; and
FIG. 20 is a perspective view illustrating an electronic device to which a display device according to an embodiment is applied.

### DETAILED DESCRIPTION

The disclosure may be modified in various ways and have various embodiments, and particular embodiments are illustrated in the drawings and described in detail through the detailed description. The effects and features of the disclosure and the method for achieving them will become clear with reference to the embodiments described in detail below together with the drawings. However, the disclosure is not necessarily limited to the embodiments provided below and may be implemented in various forms.

In the following embodiments, the terms first, second, etc. are used for the purpose of distinguishing one component from another component, and not necessarily in a limited sense.

In the following embodiments, the singular expression may include the plural expression unless the context clearly indicates otherwise.

In the embodiments below, the terms such as include or have refer to the presence of features or components described herein and do not necessarily preclude the possibility of one or more other features or components being added in advance.

In the following embodiments, when a portion such as a unit, an area, or a component is referred to as being above or on another portion, this includes not only the case where it is directly on the other portion, but also the case where there is another unit, area, or component intervening in between.

**In** the following embodiments, the terms such as connect or combine do not necessarily mean direct and/or fixed connection or combination of two members unless the context clearly indicates otherwise, and do not exclude another member being located between the two members.

While each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the scope of the present disclosure, for example, to allow for manufacturing limitations and the like.

**In** addition, the terms such as "under", "below", "on", and "above" are used to describe an association relationship between components illustrated in the drawings. The above terms are relative concepts and are described on the basis of directions indicated in the drawings. As used herein, the terms "disposed on" may refer to the case where a member is disposed not only on any one member but also below the member.

**In** addition, throughout the description, when it is referred to as "on a plane", or "in a plan view" this means when a target portion is viewed from above, and when it is referred to as "on a cross-section", or "in a cross-sectional view" this means when the target portion is viewed from the side in a cross-section cut vertically.

Hereinafter, embodiments are described in detail with reference to the accompanying drawings, and when described with reference to the drawings, the same or corresponding components may be given the same reference numerals, and to the extent that an element is not described in detail with respect to this figure, it may be understood that the element is at least similar to a corresponding element that has been described elsewhere within the present disclosure.

Embodiments of the present disclosure relate to a display device with improved anti-reflective properties, achieved without relying on a traditional polarizer. Instead, the device uses a multilayer optical control module that combines a first film layer with uniaxially stretched polymer that aligns polymer chains to form an optical axis, enabling linear polarization without absorbing visible light, thereby maintaining high transmittance (e.g., ≥85%) and reducing power consumption compared to traditional polarizers.

The device may further use a phase difference layer composed of one or more retardation layers (such as λ/4 and optionally λ/2), which alter the polarization state of light (e.g., converting linearly polarized light into circularly polarized light) to suppress internal reflections and enhance visual clarity.

An optional dye may be incorporated into the film layer to selectively absorb certain wavelengths (like blue light) and reduce unwanted color shifts or bluish tints from reflections.

A surface treatment layer, including multiple refractive index coatings and potentially a fingerprint-resistant top layer, may additionally be included to further minimize surface reflections and improve the durability and usability of the display.

This configuration enables the display device to perform the light control functions of a polarizer without the transmittance losses typical of conventional polarizing films. As a result, it may achieve high brightness and contrast, reduced reflections, and potentially improved flexibility and product longevity, making it particularly suitable for modern thin, foldable, or wearable electronic devices.

Hereinafter, the disclosure is described in detail with reference to embodiments illustrated in the attached drawings.

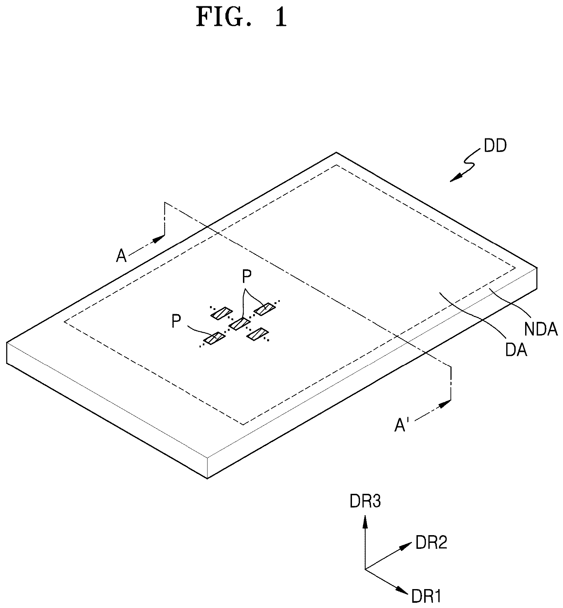

FIG. 1 is a perspective view schematically illustrating a display device according to an embodiment.

Referring to FIG. 1, a display device DD, according to an embodiment, may be a device activated according to an electrical signal. Although FIG. 1 illustrates that the display device DD is a mobile phone, the scope of the disclosure is not necessarily limited thereto.

The display device DD, according to an embodiment, may include a display surface defined in a first direction DR1 and a second direction DR2 intersecting the first direction DR1. Images generated by the display device DD may be provided to a user through the display surface.

Hereinafter, a direction substantially perpendicular to a plane defined by the first direction DR1 and the second direction DR2 may be defined as a third direction DR3. The third direction DR3 may operate as a reference for distinguishing front surfaces (upper surfaces) and rear surfaces (lower surfaces) of respective members. In the present description, "on a plane" or "in a plan view" may be defined as a state viewed in the third direction DR3.

The display device DD, according to an embodiment, may include a display area DA and a non-display area NDA beyond (e.g., surrounding) the display area DA. Although FIG. 1 illustrates that the display area DA has an approximately rectangular shape, the disclosure is not necessarily limited thereto. The display area DA may be provided in various shapes such as a circle, an ellipse, and a polygon.

The display area DA may be a portion for displaying an image, and a plurality of pixels P may be arranged in the display area DA. Hereinafter, in the present description, the term "pixel" may refer to a "sub-pixel". Each pixel P may include a light-emitting device such as an organic light-emitting diode (OLED). Each pixel P may emit, for example, light of red, green, blue, or white.

The display area DA may provide a certain image through light emitted from the pixels P. As described above, the pixel P in the present description may be defined as a light-emitting area that emits light of any one color from among red, green, blue, and white.

The non-display area NDA may be an area in which the pixels P are omitted and may be an area that does not provide an image. A printed circuit board including a power supply line and a driving circuit unit for driving the pixels P, a terminal unit to which a driver IC is connected, or the like may be arranged in the non-display area NDA.

Hereinafter, an organic light-emitting diode (OLED) display device is described as an example of the display device DD, according to an embodiment. However, the display device DD, according to an embodiment, is not necessarily limited thereto. The display device DD, according to an embodiment, may be a display device such as an inorganic light-emitting display (or an inorganic electroluminescence (EL) display) or a quantum dot light-emitting display. For example, a light-emitting layer included in a light-emitting device provided in the display device DD may include an organic material or an inorganic material. In some embodiments, quantum dots may be located on a path of light emitted from the light-emitting layer.

In some embodiments, the display device DD, according to an embodiment, may be applied to various products such as a television, a notebook/laptop computer, a computer monitor, a digital billboard, and an Internet of Things (IoT) device, as well as a portable electronic device such as a mobile phone, a smart phone, a tablet computer, a mobile communication terminal, an electronic notebook, an electronic book, a portable multimedia player (PMP), a navigation system, or ultra mobile personal computer (PC) (UMPC). In some embodiments, the display device DD, according to an embodiment, may be applied to a wearable device such as a smart watch, a watch phone, a glasses-type display, or a head mounted display (HMD). In some embodiments, the display device DD, according to an embodiment, may be applied to a center information display (CID) arranged on an instrument panel of a vehicle and a center fascia or dashboard of the vehicle, a display replacing a side mirror of the vehicle, and a display screen arranged on a rear surface of a front seat, which is entertainment for a rear seat of the vehicle.

The display device DD may include a folding area and a plurality of non-folding areas. For example, the display device DD may have a structure in which the folding area is arranged between the non-folding areas. For example, the display device DD may be folded so that the non-folding areas face each other, and the display surface may be inner-folded so that the display surfaces protect one another and are not exposed. The folding area may be outer-folded so that the display surface remain visible while folded.

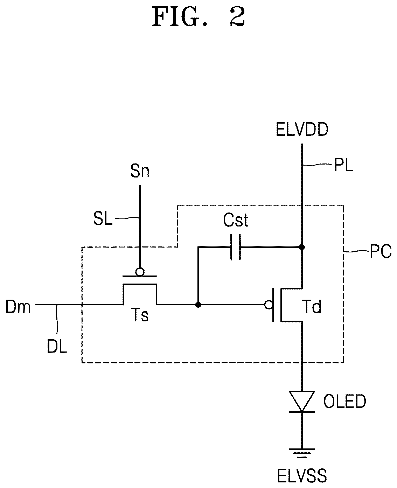

FIG. 2 is a circuit diagram schematically illustrating a display element provided in one pixel of a display device and a pixel circuit connected thereto, according to an embodiment.

Referring further to FIG. 2, each pixel P may include a pixel circuit PC connected to a scan line SL and a data line DL, and an organic light-emitting diode OLED connected to the pixel circuit PC.

The pixel circuit PC may include a driving thin film transistor Td, a switching thin film transistor Ts, and a storage capacitor Cst. The switching thin film transistor Ts may be connected to the scan line SL and the data line DL, and may transmit a data signal Dm input through the data line DL to the driving thin film transistor Td according to a scan signal Sn input through the scan line SL.

The storage capacitor Cst may be connected to the switching thin film transistor Ts and a driving voltage line PL, and may store a voltage corresponding to a difference between a voltage received from the switching thin film transistor Ts and a first power voltage ELVDD or a driving voltage, which is supplied to the driving voltage line PL.

The driving thin film transistor Td may be connected to the driving voltage line PL and the storage capacitor Cst, and may control a driving current flowing through the organic light-emitting diode OLED from the driving voltage line PL in response to a voltage value stored in the storage capacitor Cst. The organic light-emitting diode OLED may emit light having certain luminance by the driving current.

FIG. 2 illustrates that the pixel circuit PC includes two thin film transistors and one storage capacitor, but the disclosure is not necessarily limited thereto. In an embodiment, the pixel circuit PC may include, for example, seven thin film transistors and one storage capacitor. In an embodiment, the pixel circuit PC may include two or more storage capacitors.

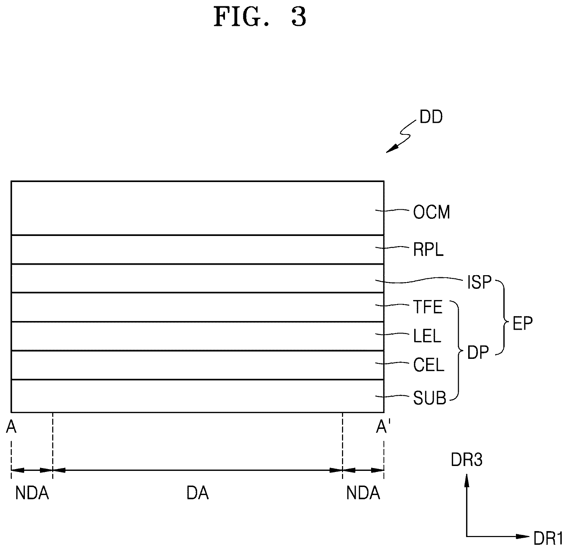

FIG. 3 is a cross-sectional view schematically illustrating a display device DD according to an embodiment.

Referring to FIG. 3, the display device DD, according to an embodiment, includes an electronic panel EP, an anti-reflection layer RPL, and an optical control module OCM.

The electronic panel EP may include a display panel DP and an input sensor ISP disposed on the display panel DP. The display panel DP may include a base layer SUB, a circuit layer CEL disposed on the base layer SUB, a light-emitting device layer LEL disposed on the circuit layer CEL, and a thin film encapsulation layer TFE disposed on the light-emitting device layer LEL.

The base layer SUB may provide a base surface on which the circuit layer CEL is disposed. The base layer SUB may be a flexible substrate that may be bent, folded, rolled, or the like, to at least a noticeable extent without cracking or otherwise sustaining damage thereto. The base layer SUB may be a glass substrate, a metal substrate, a polymer substrate, or the like. However, an embodiment is not necessarily limited thereto, and the base layer SUB may be an inorganic layer, an organic layer, or a composite material layer.

The circuit layer CEL may be disposed on the base layer SUB. The circuit layer CEL may include insulating layers, transistors each including a semiconductor pattern, circuit lines connected to the transistors, conductive patterns, and the like.

The light-emitting device layer LEL may be disposed on the circuit layer CEL. The light-emitting device layer LEL may include a light-emitting device. For example, the light-emitting device may include an organic light-emitting material, an inorganic light-emitting material, organic-inorganic light-emitting material, a quantum dot, a quantum rod, a micro LED, or a nano LED.

The thin film encapsulation layer TFE may be disposed on the light-emitting device layer LEL. The thin film encapsulation layer TFE may protect the light-emitting device layer LEL from foreign substances such as moisture, oxygen, and dust particles. The thin film encapsulation layer TFE may include at least one inorganic layer. The thin film encapsulation layer TFE may include a stack structure of an inorganic layer, an organic layer, and an inorganic layer.

The input sensor ISP may include a plurality of electrodes for detecting an external input, trace lines connected to the plurality of electrodes, and an organic layer and/or an inorganic layer for insulating or protecting the plurality of electrodes or trace lines. The input sensor ISP may be a capacitive sensor, but is not necessarily limited to being capacitive.

The input sensor ISP may be directly disposed on the display panel DP. The display panel DP and the input sensor ISP may be formed together through a single continuous process. Therefore, a separate adhesive layer might not be arranged between the input sensor ISP and the display panel DP.

The display device DD, according to an embodiment, may include the anti-reflection layer RPL. The anti-reflection layer RPL may reduce a reflectivity of external light incident from the outside of the display device DD. Here, although the anti-reflection layer RPL is illustrated as being directly disposed on the input sensor ISP, the scope of the disclosure is not necessarily limited thereto, and the input sensor ISP may be disposed on the anti-reflection layer RPL.

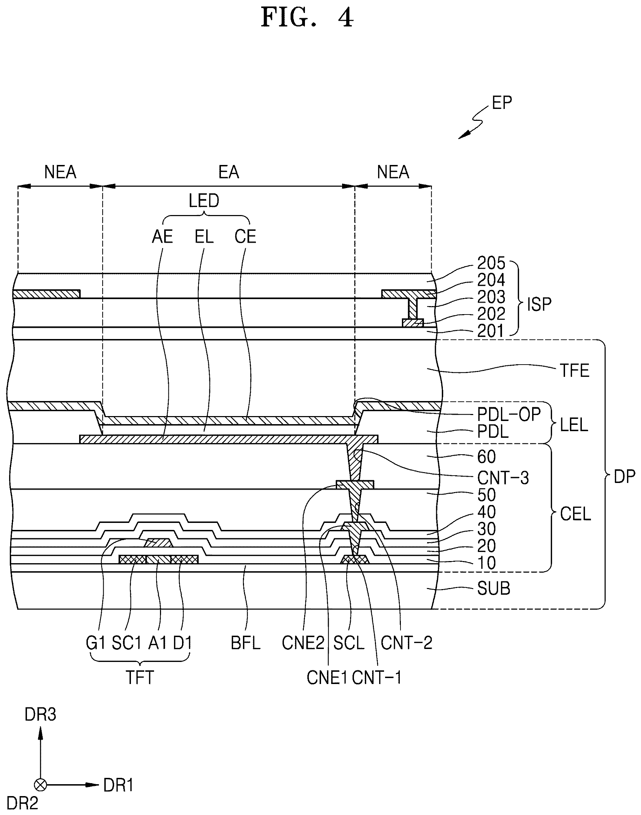

FIG. 4 is a cross-sectional view schematically illustrating an electronic panel EP according to an embodiment. Although only one light-emitting area EA is illustrated in FIG. 4, this is an example, and a plurality of light-emitting areas EA may be provided.

Referring to FIG. 4, the electronic panel EP, according to an embodiment, may include a display panel DP and an input sensor ISP.

Here, the display panel DP may include a base layer SUB, a circuit layer CEL, a light-emitting device layer LEL, and a thin film encapsulation layer TFE.

The base layer SUB may have a multilayer structure. For example, the base layer SUB may have a three-layer structure of a synthetic resin layer, an adhesive layer, and a synthetic resin layer. For example, the synthetic resin layer may include a polyimide-based resin. In some embodiments, the synthetic resin layer may include an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, and/or a perylene-based resin.

The circuit layer CEL may be disposed on the base layer SUB. The circuit layer CEL may include an insulating layer, a semiconductor pattern, a conductive pattern, a signal line, a driving circuit of a pixel, and the like. For example, the circuit layer CEL may include a buffer layer BFL, a first insulating layer 10, a second insulating layer 20, a third insulating layer 30, a fourth insulating layer 40, and a fifth insulating layer 50, a signal transmission area SCL, and a plurality of connection electrodes including a first connection electrode CNE1 and a second connection electrode CNE2.

The buffer layer BFL may be disposed on the base layer SUB. The buffer layer BFL may prevent metal atoms or impurities from being diffused from the base layer SUB into a semiconductor pattern on the base layer SUB. The semiconductor pattern may include an active area A1 of the transistor TFT. A rear metal layer may be additionally arranged between the base layer SUB and the buffer layer BFL. The rear metal layer may be arranged below the transistor TFT and may block external light from reaching the transistor TFT.

The semiconductor pattern may be disposed on the buffer layer BFL. The semiconductor pattern may include silicon semiconductor. For example, the silicon semiconductor may include amorphous silicon, polycrystalline silicon, or the like. For example, the semiconductor pattern may include low-temperature polysilicon.

The transistor TFT may include a source area SC1 (or a source), the active area A1 (or a channel), a drain area D1 (or a drain), and a gate G1. The source area SC1, the active area A1, and the drain area D1 of the transistor TFT may be formed from the semiconductor pattern. The source area SC1 and the drain area D1 may extend from the active area A1 in opposite directions to each other on a cross-section. FIG. 4 illustrates a portion of the signal transmission area SCL formed from the semiconductor pattern. The signal transmission area SCL may be connected to the drain area D1 of the transistor TFT on a plane.

The first insulating layer 10 may be disposed on the buffer layer BFL. The first insulating layer 10 may cover the source area SC1, the active area A1, the drain area D1, and the signal transmission area SCL of the transistor TFT disposed on the buffer layer BFL.

The first insulating layer 10 may include an inorganic layer and/or an organic layer, and may have a single layer or multilayer structure. The inorganic layer may include aluminum oxide, titanium oxide, silicon oxide, silicon nitride, silicon oxynitride, zirconium oxide, and/or hafnium oxide. In the present embodiment, the first insulating layer 10 may be a silicon oxide layer of a single layer. An insulating layer of the circuit layer CEL described below, as well as the first insulating layer 10, may be an inorganic layer and/or an organic layer, and may have a single layer or multilayer structure. The inorganic layer may include at least one of the materials described above, but is not necessarily limited thereto.

The gate G1 of the transistor TFT may be disposed on the first insulating layer 10. The gate G1 may be a portion of a metal pattern. The gate G1 may overlap the active area A1. The gate G1 may function as a mask in a process of doping the semiconductor pattern. The gate G1 may include titanium (Ti), silver (Ag), an alloy containing silver (Ag), molybdenum (Mo), an alloy containing molybdenum (Mo), aluminum (Al), an alloy containing aluminum (Al), aluminum nitride (AIN), tungsten (W), tungsten nitride (WN), copper (Cu), indium tin oxide (ITO), indium zinc oxide (IZO), or the like, but is not necessarily limited thereto.

The second insulating layer 20 may be disposed on the first insulating layer 10 and may cover the gate G1. The third insulating layer 30 may be disposed on the second insulating layer 20.

The first connection electrode CNE1 may be disposed on the third insulating layer 30. The first connection electrode CNE1 may be connected to the signal transmission area SCL through a contact hole CNT-1 passing through the first insulating layer 10, the second insulating layer 20, and the third insulating layer 30. The fourth insulating layer 40 may be disposed on the third insulating layer 30 to cover the first connection electrode CNE1. The fourth insulating layer 40 may be an organic layer.

The fifth insulating layer 50 may be disposed on the fourth insulating layer 40. The second connection electrode CNE2 may be disposed on the fifth insulating layer 50. The second connection electrode CNE2 may be connected to the first connection electrode CNE1 through a contact hole CNT-2 passing through the fourth insulating layer 40 and the fifth insulating layer 50. The fifth insulating layer 50 may be an organic layer.

The sixth insulating layer 60 may be disposed on the fifth insulating layer 50 to cover the second connection electrode CNE2. The sixth insulating layer 60 may be an organic layer. A stack structure of the first insulating layer 10, the second insulating layer 20, the third insulating layer 30, the fourth insulating layer 40, the fifth insulating layer 50, and the sixth insulating layer 60 is an example, and additional conductive layers and insulating layers may be further arranged in addition to the first insulating layer 10, the second insulating layer 20, the third insulating layer 30, the fourth insulating layer 40, the fifth insulating layer 50, and the sixth insulating layer 60.

The light-emitting device layer LEL may be disposed on the circuit layer CEL. The light-emitting device layer LEL may include a light-emitting device LED and a pixel defining layer PDL. For example, the light-emitting device layer LEL may include an organic light-emitting material, a quantum dot, a quantum rod, a micro LED, or a nano LED.

The light-emitting device LED may include a first electrode AE, a light-emitting layer EL, and a second electrode CE.

The first electrode AE may be disposed on the sixth insulating layer 60. The first electrode AE may be connected to the second connection electrode CNE2 through a contact hole CNT3 passing through the sixth insulating layer 60.

The pixel defining layer PDL may be disposed on the sixth insulating layer 60 and may cover a portion of the first electrode AE. An opening PDL-OP may be defined in the pixel defining layer PDL. The opening PDL-OP of the pixel defining layer PDL may expose at least a portion of the first electrode AE. In the present embodiment, the light-emitting area EA may be defined to correspond to a partial area of the first electrode AE exposed by the opening PDL-OP. A non-light-emitting area NEA may surround the light-emitting area EA.

The light-emitting layer EL may be disposed on the first electrode AE. The light-emitting layer EL may be arranged in the opening PDL-OP. For example, the light-emitting layer EL may be formed separately from each of pixels. In the case where the light-emitting layer EL is formed separately from each of the pixels, each of the light-emitting layers EL may emit light of at least one color from among blue, red, and green colors. However, the light-emitting layer EL is not necessarily limited thereto, and may be connected to the pixels and provided in common. Here, the light-emitting layer EL may provide blue light or white light.

The second electrode CE may be disposed on the light-emitting layer EL. The second electrode CE may have a singular, integral shape and may be commonly arranged in a plurality of pixels. A common voltage may be provided to the second electrode CE, and the second electrode CE may be referred to as a common electrode.

The light-emitting layer EL may be an organic light-emitting layer including an organic material. The light-emitting layer EL may include a hole transporting layer, an organic light-emitting layer, and an electron transporting layer. In the case where the first electrode AE receives a certain voltage through a thin film transistor of the circuit layer CEL and the second electrode CE receives a common voltage, holes and electrons may move to the organic light-emitting layer through the hole transporting layer and the electron transporting layer, respectively, and may combine with each other in the organic light-emitting layer to emit light. For example, the first electrode AE may be an anode electrode, and the second electrode CE may be a cathode electrode, but the first electrode AE and the second electrode CE are not necessarily limited thereto.

For example, a plurality of light-emitting devices LED may include a quantum dot light-emitting diode including a quantum dot light-emitting layer, an inorganic light-emitting diode including inorganic semiconductor, or a micro light-emitting diode.

A thin film encapsulation layer TFE may be disposed on the second electrode CE. The thin film encapsulation layer TFE may be provided as a multilayer structure in which at least one organic encapsulation layer and at least one inorganic encapsulation layer are alternately stacked. The thin film encapsulation layer TFE may protect a display unit from external moisture permeation.

The organic encapsulation layer may provide a more planarized base surface, and thus, a defect rate may be reduced even in the case where an input sensor ISP described below is formed by a single continuous process.

The input sensor ISP may include a base insulating layer 201, a first conductive layer 202, a detection insulating layer 203, a second conductive layer 204, and a cover insulating layer 205.

The base insulating layer 201 may be an inorganic layer including silicon nitride, silicon oxynitride, and/or silicon oxide. Alternatively, the base insulating layer 201 may be an organic layer including an epoxy resin, an acrylic resin, or an imide-based resin. The base insulating layer 201 may have a single layer structure or a multilayer structure stacked in a third direction DR3.

Each of the first conductive layer 202 and the second conductive layer 204 may have a single layer structure or a multilayer structure stacked in the third direction DR3.

A conductive layer having a single layer structure may include a metal layer or a transparent conductive layer. The metal layer may include molybdenum, silver, titanium, copper, aluminum, or an alloy thereof. The transparent conductive layer may include transparent conductive oxide such as indium tin oxide (ITO), indium zinc oxide (IZO), zinc oxide (ZnO), or indium zinc tin oxide (IZTO).

A conductive layer having a multilayer structure may include metal layers. The metal layers may each have, for example, a three-layer structure of titanium, aluminum, and titanium. The conductive layer having the multilayer structure may include at least one metal layer and at least one transparent conductive layer.

At least one of the detection insulating layer 203 and the cover insulating layer 205 may include an inorganic layer. The inorganic layer may include aluminum oxide, titanium oxide, silicon oxide, silicon oxynitride, zirconium oxide, and/or hafnium oxide.

At least one of the detection insulating layer 203 and the cover insulating layer 205 may include an organic layer. The organic layer may include an acrylate-based resin, a methacrylate-based resin, a polyisoprene-based resin, a vinyl-based resin, an epoxy-based resin, a urethane-based resin, a cellulose-based resin, a siloxane-based resin, a polyimide-based resin, a polyamide-based resin, and/or a perylene-based resin.

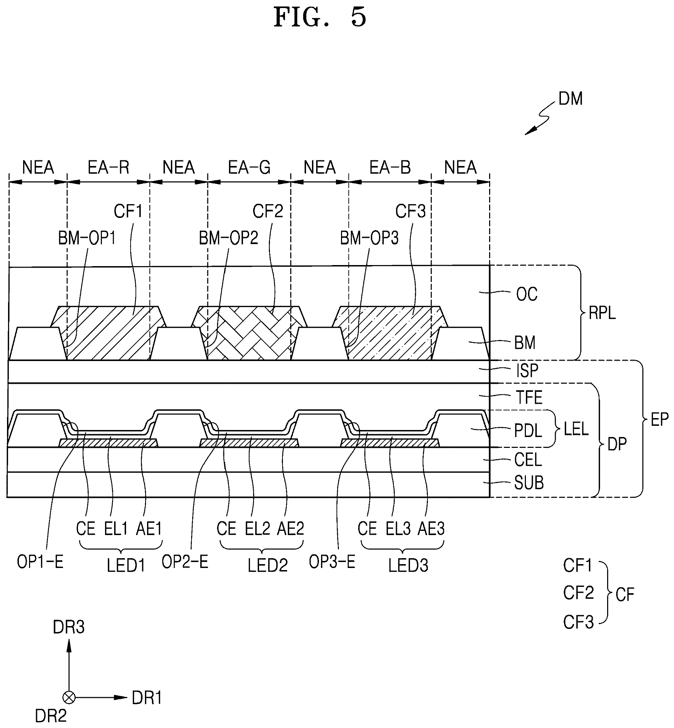

FIG. 5 is a cross-sectional view schematically illustrating a display module DM according to an embodiment.

Referring to FIG. 5, a display panel DP may include a first light-emitting device LED1, a second light-emitting device LED2, and a third light-emitting device LED3. The first light-emitting device LED1 may include a first anode AE1, a first light-emitting layer EL1, and a portion of a cathode CE. The second light-emitting device LED2 may include a second anode AE2, a second light-emitting layer EL2, and a portion of the cathode CE. The third light-emitting device LED3 may include a third anode AE3, a third light-emitting layer EL3, and a portion of the cathode CE.

The first anode AE1, the second anode AE2, and the third anode AE3 may be provided in a plurality of patterns. A first light-emitting opening OP1-E, a second light-emitting opening OP2-E and a third light-emitting opening OP3-E may be defined in a pixel defining layer PDL. The first light-emitting opening OP1-E may expose at least a portion of the first anode AE1. The second light-emitting opening OP2-E may expose at least a portion of the second anode AE2. The third light-emitting opening OP3-E may expose at least a portion of the third anode AE3.

The first light-emitting layer EL1, the second light-emitting layer EL2, and the third light-emitting layer EL3 may be arranged on the first anode AE1, the second anode AE2, and the third anode AE3, and the pixel defining layer PDL. The first light-emitting layer EL1, the second light-emitting layer EL2, and the third light-emitting layer EL3 may be arranged in the first light-emitting opening OP1-E, the second light-emitting opening OP2-E, and the third light-emitting opening OP3-E. The first light-emitting layer EL1 may be arranged in the first light-emitting opening OP1-E, the second light-emitting layer EL2 may be arranged in the second light-emitting opening OP2-E, and the third light-emitting layer EL3 may be arranged in the third light-emitting opening OP3-E. The cathode CE may be disposed on the first light-emitting layer EL1, the second light-emitting layer EL2, and the third light-emitting layers EL3, and the pixel defining layer PDL.

The first light-emitting layer EL1, the second light-emitting layer EL2, and the third light-emitting layers EL3 may provide different colors. For example, the first light-emitting layer EL1 may provide red light, the second light-emitting layer EL2 may provide green light, and the third light-emitting layer EL3 may provide blue light.

An input sensor ISP may be disposed on a thin film encapsulation layer TFE, and an anti-reflection layer RPL may be disposed on the input sensor ISP. Alternatively, as a selective embodiment, the input sensor ISP may be omitted and the anti-reflection layer RPL may be disposed on the thin film encapsulation layer TFE.

A display device DD, according to an embodiment, may include the anti-reflection layer RPL including an on-cell film (OCF) that applies a light blocking pattern BM and a color filter CF instead of a polarizer.

The display device DD, according to an embodiment, may apply Pol-less technology, i.e., an arrangement in which a polarizer is omitted. An existing polarizer may be included in the display device DD to prevent reflection of external light. An organic light-emitting diode may include a circuit layer for driving the same, and various types of lines and thin film transistors included in the circuit layer may use metal materials to improve conductivity. However, metal may be highly reflective and shiny. Therefore, when viewing a display device under external lighting, external light may be reflected by the circuit layer or the like, and thus, a screen might not be easily viewed. To prevent the same, a polarizer may be included in the display device to prevent reflection of external light. The polarizer may prevent reflection of external light, but at the same time, may lower luminous efficiency of an organic light-emitting diode. In the case where light passes through the polarizer that is a semi-transparent plastic sheet, brightness may be reduced by 50% or more, and thus, light efficiency may be reduced. Here, more power consumption may be needed to increase the brightness. Also, the increase in the brightness may lead to a decrease in product life. Accordingly, according to an embodiment, a polarizer may be omitted from the display device DD, and instead, the anti-reflection layer RPL may be used to prevent reflection of external light. Accordingly, a color of the screen may be more clearly expressed and power consumption may be lowered.

The anti-reflection layer RPL, which may be an on-cell film, serves to reduce reflection of external light and may comprise a plurality of color filters CF arranged to correspond with light-emitting pixels of the display panel. To further improve contrast and reduce reflectivity from metallic components, the anti-reflection layer RPL may further comprise a light-blocking pattern BM, such as a black matrix, disposed between the color filters. Furthermore, an overcoat layer OC may be provided on top of the color filters and the light-blocking pattern to provide a planar surface for subsequent layers.

The anti-reflection layer RPL includes the color filter CF, and may further include the light blocking pattern BM and an overcoat layer OC.

The light blocking pattern BM may be disposed on the input sensor ISP. The light blocking pattern BM may be a layer having a black color, and in an embodiment, the light blocking pattern BM may include a black coloring agent. The black coloring agent may include a black dye and a black pigment. The black coloring agent may include carbon black, metal such as chromium (Cr), or an oxide thereof. However, the material constituting the light blocking pattern BM is an example and may use any material that absorbs light.

The light blocking pattern BM may prevent reflection of external light by the first conductive layer 202 (refer to FIG. 4) and the second conductive layer 204 (refer to FIG. 4). The light blocking pattern BM may overlap the pixel defining layer PDL. A first opening BM-OP1, a second opening BM-OP2, and a third opening BM-OP3 may be defined in the light blocking pattern BM. The first opening BM-OP1, the second opening BM-OP2, and the third opening BM-OP3 of the light blocking pattern BM may overlap the first light-emitting opening OP1-E, the second light-emitting opening OP2-E, and the third light-emitting opening OP3-E of the pixel defining layer PDL. The first opening BM-OP1 may overlap the first light-emitting opening OP1-E, the second opening BM-OP2 may overlap the second light-emitting opening OP2-E, and the third opening BM-OP3 may overlap the third light-emitting opening OP3-E.

The first opening BM-OP1, the second opening BM-OP2, and the third opening BM-OP3 of the light blocking pattern BM may define a first pixel area EA-R, a second pixel area EA-G, and a third pixel area EA-B. The first pixel area EA-R, the second pixel area EA-G, and the third pixel area EA-B may be respectively defined as areas from which light generated by the first light-emitting device LED1, the second light-emitting device LED2, and the third light-emitting device LED3 is emitted to the outside.

In the case of a display device, a color filter may be arranged above each pixel to reduce reflection of external light. For example, a red color filter, which passes only red light, may be arranged above a pixel that emits red light, and a blue color filter, which passes only blue light, may be arranged above a pixel that emits blue light. Accordingly, in the case where external light, which is white light, is incident, for example, on the red color filter, blue light and green light may be absorbed by the red color filter, and only red light may pass through the red color filter, be reflected from a pixel electrode, pass through the red color filter again, and be emitted to the outside. Therefore, in the case of a display device having a color filter, reflection of external light may be reduced to about 1/3 compared to the case without a color filter.

In some embodiments, the color filter CF may include a first color filter CF1, a second color filter CF2, and a third color filter CF3. The first color filter CF1, the second color filter CF2, and the third color filter CF3 may transmit light generated by the first light-emitting device LED1, the second light-emitting device LED2, and the third light-emitting device LED3 and block some wavelength bands of external light, in correspondence to the first light-emitting device LED1, the second light-emitting device LED2, and the third light-emitting device LED3.

The first color filter CF1 may transmit a first color, the second color filter CF2 may transmit a second color and a third color, and the third color filter CF3 may transmit the third color.

For example, in the case where a light-emitting layer of the first light-emitting device LED1 located under the first color filter CF1 emits blue light, the first color filter CF1 may be a blue color filter, and in the case where a light-emitting layer of the second light-emitting device LED2 located under the second color filter CF2 emits red light, the second color filter CF2 may be a red color filter. However, in the case where a light-emitting layer of a light-emitting device LED emits green light, a color filter might not be arranged above the corresponding light-emitting device.

The first color filter CF1, the second color filter CF2, and the third color filter CF3 may reduce reflection of external light by the first anode AE1, the second anode AE2, and the third anode AE3 or the cathode CE.

The first color filter CF1, the second color filter CF2, and the third color filter CF3 may overlap at least the first pixel area EA-R, the second pixel area EA-G, and the third pixel area EA-B. In some embodiments, the first color filter CF1 may overlap the first light-emitting device ED1, the second color filter CF2 may overlap the second light-emitting device LED2, and the third color filter CF3 may overlap the third light-emitting device LED3. Some of the first color filter CF1, the second color filter CF2, and the third color filter CF3 may also overlap a non-pixel area NEA. For example, a portion of the color filter CF may be disposed on the light blocking pattern BM.

The anti-reflection layer RPL does not need to include all of the first color filter CF1, the second color filter CF2, and the third color filter CF3, and may also include two color filters selected from among the first color filter CF1, the second color filter CF2, and the third color filter CF3.

The overcoat layer OC may cover the light blocking pattern BM, the first color filter CF1, the second color filter CF2, and the third color filter CF3. The overcoat layer OC may include an organic material and may provide a flat upper surface.

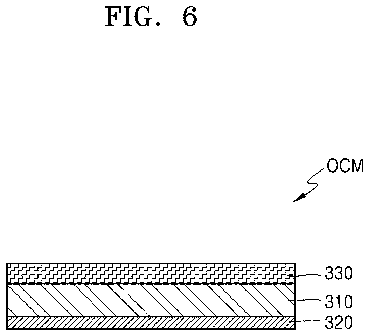

FIG. 6 is a cross-sectional view schematically illustrating an optical control module OCM according to an embodiment.

First, referring to FIG. 3, the optical control module OCM may be arranged above the display panel DP or the electronic panel EP. In some embodiments, the optical control module OCM may be disposed on the anti-reflection layer RPL.

Referring to FIG. 6, an optical control module OCM, according to an embodiment, includes a first film layer 310 and a phase difference layer 320, and may further include a surface treatment layer 330.

Here, the first film layer 310 may function as a support for the phase difference layer 320 or the surface treatment layer 330. For example, the first film layer 310 may provide a surface on which the phase difference layer 320 or the surface treatment layer 330 is disposed.

For example, the phase difference layer 320 may be arranged below the first film layer 310, and the surface treatment layer 330 may be disposed on the first film layer 310. The above example is described in more detail below.

The first film layer 310 may include a light transmitting film including a polymer resin. For example, the first film layer 310 may include polyethylene terephthalate (PET), polyvinyl alcohol (PVA), polycarbonate (PC), polymethyl methacrylate (PMMA), polystyrene (PS), polypropylene (PP), and/or triacetyl cellulose (TAC).

The first film layer 310 may include a transparent optical film in which polymer chain alignment is performed by a uniaxial stretching process.

In some embodiments, the first film layer 310 may be a polymer film produced by uniaxially stretching an unstretched film in a machine direction (MD) or a transverse direction (TD).

Accordingly, the first film layer 310 includes a first optical axis corresponding to a stretching axis in one direction.

In some embodiments, the first film layer 310 may be a light transmitting film capable of implementing a linear polarization function along the first optical axis. For example, the first film layer 310 may polarize light incident from a light source into light in the same direction as the first optical axis.

Therefore, the display device DD, according to an embodiment, may generate linearly polarized light through the first film layer 310 and generate circularly polarized light by a phase retardation layer described below to lower an internal reflectivity of light reflected by the display panel DP. The above example is described in more detail below.

Here, different from a polarizer, the first film layer 310 might not include a light absorption axis. For example, the polarizer may be manufactured by stretching a polyvinyl alcohol (PVA) film in one direction and immersing the stretched PVA film in a solution of an iodine and/or dichroic dye to arrange iodine molecules and/or dichroic dye molecules side by side in a stretching direction. The iodine molecules and dye molecules may be dichroic and thus may absorb light vibrating in the stretching direction and transmit light vibrating in a direction perpendicular to the stretching direction. Therefore, the polarizer may have a visible light transmittance that is reduced to 50% or less.

In some embodiments, the first film layer 310, according to an embodiment, might not include the light absorption axis and thus have a higher visible light transmittance than the polarizer. For example, the visible light transmittance of the first film layer 310 may be 85 % or more. The first film layer 310 may have an average transmittance for visible light of at least 85%. Preferably, the transmittance is at least 90% to maximize luminous efficiency. In some embodiments, the transmittance may be in a range of from 85% to 95%, which represents a practical range that balances high optical performance with manufacturing feasibility.

Accordingly, the display device DD, according to an embodiment, may minimize the internal reflectivity of the display panel DP by generating some polarization functions while minimizing a decrease in a transmittance compared to the polarizer by using the first film layer 310.

With respect to the first film layer 310, a modulus in a first direction corresponding to the first optical axis may be greater than a modulus in a second direction orthogonal to the first direction. In some embodiments, with respect to the first film layer 310, a modulus in the TD may be greater than a modulus in the MD.

For example, with respect to the first film layer 310, a difference between the modulus in the first direction and the modulus in the second direction may be 1 Gpa or more. In some embodiments, with respect to the first film layer 310, a difference between the modulus in the TD and the modulus in the MD may be 0.5 Gpa or more and 3 Gpa or less. In some embodiments, the first film layer 310 may be a film having a stretch rate of 1.5 times or more and 4 times or less. The difference between the modulus in the first direction and the modulus in the second direction may be within a range of from 0.5 GPa to 3.0 GPa. In a preferred embodiment, this difference is in a sub-range of 1.0 GPa to 3.0 GPa. A greater modulus difference in this higher sub-range can correspond to a more pronounced alignment of the polymer chains, resulting in a more robust linear polarization function and a further improved anti-reflection performance. The first film layer may be formed with an elongation ratio, or stretch rate, of between 1.5 times and 4 times. A preferred sub-range may be from 1.5 times to 3.0 times. A more particular sub-range of 2.0 times to 3.0 times may be used to achieve a more complete and uniform alignment of the polymer chains, resulting in a highly effective linear polarization function. A lower sub-range, for example from 1.5 times to 2.0 times, may be advantageous for manufacturing efficiency or for use with certain polymer materials. The industry-standard test methods used to determine the MD/TD modulus of the first film layer (highly-drawn film) are ASTM D882 and KS M ISO 527-3 (Type 2). The evaluation conditions used are: the measured piece of the film layer has a size of 10 mm for the width and 100 mm for the length, the environment is at room temperature and the crosshead speed is 10 mm/min.

The first film layer 320 may have a particular elongation ratio within a range of 1.5 times to 3 times, inclusive. This means that the length of the first film layer 320 may stretch to between 1.5 times to 3 times its length when unstretched. The phase difference layer 320 functions to alter the polarization state of light. It may be a single-layer or multi-layer component comprising one or more phase retardation layers. For example, the phase difference layer 320 may comprise a quarter-wave λ/4 phase retardation layer 321. In other embodiments, to achieve broadband performance, it may comprise a combination of a quarter-wave λ/4 phase retardation layer 321 and a half-wave λ/2 phase retardation layer 322.

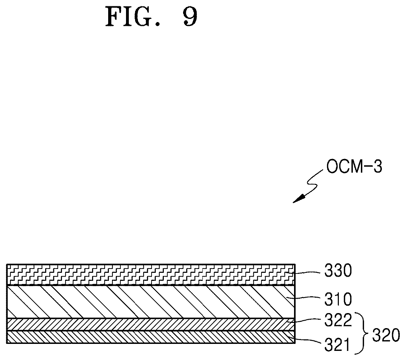

In some embodiments, the phase difference layer 320 may be arranged below the first film layer 310. The phase difference layer 320 may be a functional layer including one or more phase retardation layers. In an embodiment, the phase difference layer 320 may include a λ/4 phase retardation layer 321 (refer to FIG. 9) (i.e., a quarter wave plate).

The λ/4 phase retardation layer 321 may be an optical layer that delays a phase of provided light by λ/4. For example, in the case where a wavelength of light transmitted through the first film layer 310 and provided to the λ/4 phase retardation layer 321 is 550 nm, the light passing through the λ/4 phase retardation layer 321 may have a phase delay value of 137.5 nm.

In some embodiments, the λ/4 phase retardation layer 321 may have optical anisotropy and may change a polarization state of light incident on the λ/4 phase retardation layer 321. For example, the light transmitted through the first film layer 310 and provided to the λ/4 phase retardation layer 321 may be changed from a linearly polarized state to a circularly polarized state. In some embodiments, the light provided to the λ/4 phase retardation layer 321 in the circularly polarized state may be change to a linearly polarized state.

In the phase difference layer 320, according to an embodiment, the λ/4 phase retardation layer 321 may be a liquid crystal coating layer. The λ/4 phase retardation layer 321 may be a liquid crystal coating layer manufactured by using a reactive liquid crystal monomer. The λ/4 phase retardation layer 321 may be manufactured by coating and aligning a reactive liquid crystal monomer and then polymerizing the same. For example, the liquid crystal monomer used in the λ/4 phase retardation layer 321 may have a rod-shaped nematic phase. For example, the λ/4 phase retardation layer 321 may be a nematic liquid crystal coating layer. The λ/4 phase retardation layer 321 may include only a liquid crystal coating layer without a base substrate that is a support. A total thickness of the display device DD may be reduced by using, in the phase difference layer 320, the λ/4 phase retardation layer 321 including only the liquid crystal coating layer without including the base substrate. For example, a thickness of the optical control module OCM may be reduced by using the λ/4 phase retardation layer 321, which is the liquid crystal coating layer, and thus, the display device DD may be more easily bent.

The λ/4 phase retardation layer 321 may be a phase retardation layer having reverse wavelength dispersion. For example, the phase delay value may also increase with an increase in a light wavelength, and thus, the λ/4 phase retardation layer 321 may implement relatively uniform phase delay in a relatively wide light wavelength band. Here, the phase difference layer 320 may be a single layer that is the λ/4 phase retardation layer 321 having the reverse wavelength dispersion.

**In** an embodiment, the λ/4 phase retardation layer 321 may be a phase difference film having reverse wavelength dispersion.

However, the scope of the disclosure is not necessarily limited thereto, and the λ/4 phase retardation layer 321 may be a phase retardation layer having normal wavelength dispersion.

The phase difference layer 320 may be a single layer that is the λ/4 phase retardation layer 321. The phase difference layer 320 is not necessarily limited thereto and may further include a λ/2 phase retardation layer 322 (refer to FIG. 9) i.e., a half wave plate. The above example is described in detail below.

The surface treatment layer 330 may be disposed on the first film layer 310. For example, the surface treatment layer 330 may be arranged on the outermost layer of the optical control module OCM. Alternatively, the surface treatment layer 330 may be disposed on the outermost layer of the display device DD.

The surface treatment layer 330 may be coated on the first film layer 310 to lower a surface reflectivity.

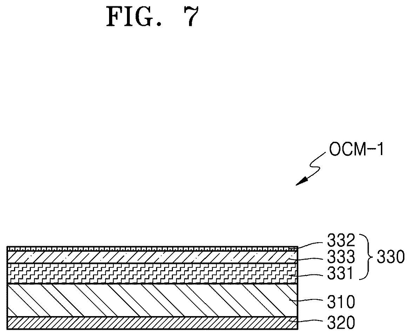

Here, the surface treatment layer 330 may include a hard coating layer 331 (refer to FIG. 7). In some embodiments, the surface treatment layer 330 may include a fingerprint preventing layer 332 (refer to FIG. 7) on the outermost layer.

The hard coating layer 331 may be formed from a hard coating layer resin including an organic composition, an inorganic composition, and/or an organic-inorganic composite composition. For example, a hard coating agent forming the hard coating layer 331 may include an acrylate compound, a siloxane compound, and/or a silsesquioxane compound. In some embodiments, the hard coating agent may further include inorganic particles. The hard coating layer 331 may be an organic layer, an inorganic layer, or an organic-inorganic composite material layer.

The surface treatment layer 330 may have a multilayer structure including a plurality of coating layers having different refractive indices in addition to the hard coating layer 331.

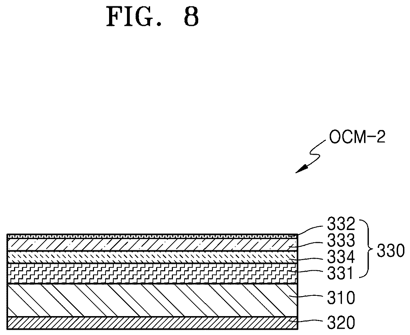

**In** some embodiments, the surface treatment layer 330 may further include one or more layers from among a low refractive index layer 333 (refer to FIG. 8) and a high refractive index layer 334 (refer to FIG. 8) arranged on the hard coating layer 331. The above example is described below.

The optical control module OCM may thus have various configurations. In some embodiments, the optical control module OCM may comprise a surface treatment layer 330 disposed on the first film layer 310. This surface treatment layer 330 may be a single layer, such as a hard coating layer 331, or a multilayer stack designed to further reduce surface reflections. For example, a multilayer stack may comprise the hard coating layer 331 and at least one of a low refractive index layer 333 and a high refractive index layer 334.

FIG. 7 is a cross-sectional view schematically illustrating an embodiment of the optical control module OCM of FIG. 6.

Referring to FIG. 7, an optical control module OCM-1 may include a first film layer 310, a phase difference layer 320, and a surface treatment layer 330. Here, the first film layer 310 and the phase difference layer 320 are substantially the same as those described in the optical control module OCM of FIG. 6, and thus, to the extent that an element is not described in detail with respect to this figure, it may be understood that the element is at least similar to a corresponding element that has been described elsewhere within the present disclosure. Hereinafter, the surface treatment layer 330 having a difference from the optical control module OCM described above is mainly described.

**In** some embodiments, the surface treatment layer 330 may include the hard coating layer 331, the low refractive index layer 333, and the fingerprint preventing layer 332.

Here, the fingerprint preventing layer 332 may be disposed on the outermost layer of the surface treatment layer 330. For example, the fingerprint preventing layer 332 may be disposed on the outermost layer of the optical control module OCM-1.

The fingerprint preventing layer 332 may include a water repellent material or an oil repellent material. In some embodiments, the fingerprint preventing layer 332 may include a fingerprint preventing material, and the fingerprint preventing material may be inorganic particles including a fluorine-based material. For example, the fingerprint preventing material may be a fluorinated silane compound in which a silane moiety and a fluorinated carbon moiety are linked by an alkyl chain. However, the disclosure is not necessarily limited thereto, and the fingerprint preventing material may be an organic material including a fluorine-based material. For example, the fingerprint preventing material may be a material such as polytetrafluoroethylene (PTFE), fluorinated ethylene propylene (FEP), or perfluoropolyether (PFPE).

**In** an embodiment, the fingerprint preventing material may be inorganic particles including a silicon-based material. For example, the fingerprint preventing material may be inorganic particles such as silica nanoparticles (SiO₂). However, the disclosure is not necessarily limited thereto, and the fingerprint preventing material may be an organic silicon compound such as hexamethyldisiloxane (HMDSO), tetraethyl orthosilicate (TEOS), or polydimethylsiloxane (PDMS).

The low refractive index layer 333 may be disposed on the hard coating layer 331. The low refractive index layer 333 may include a light transmitting inorganic or organic material having a low refractive index. For example, the inorganic material may include silicon oxide, silicon oxynitride, magnesium fluoride, or the like. The organic material may include at least one selected from the group consisting of acrylic, polyimide, polyamide, Alq3 [Tris(8-hydroxyquinolinato)aluminium], and the like. A refractive index of the low refractive index layer 333 may be about 1.2 or more. For example, the refractive index of the low refractive index layer 333 may be 1.2 to 1.5. However, the disclosure is not necessarily limited thereto.

FIG. 8 is a cross-sectional view schematically illustrating an embodiment of the optical control module OCM of FIG. 6.

Referring to FIG. 8, an optical control module OCM-2 may include a first film layer 310, a phase difference layer 320, and a surface treatment layer 330. Here, the first film layer 310 and the phase difference layer 320 are substantially the same as those described in the optical control module COM of FIG. 6, and thus, to the extent that an element is not described in detail with respect to this figure, it may be understood that the element is at least similar to a corresponding element that has been described elsewhere within the present disclosure. Hereinafter, the surface treatment layer 330 having a difference from the optical control module OCM described above is mainly described.

Referring to FIG. 8, the surface treatment layer 330 may include both the low refractive index layer 333 and the high refractive index layer 334 in addition to the hard coating layer 331. Here, the high refractive index layer 334 may be disposed on the hard coating layer 331, and the low refractive index layer 333 may be disposed on the high refractive index layer 334. In some embodiments, a fingerprint preventing layer 332 may be disposed on the low refractive index layer 333.

The hard coating layer 331, the low refractive index layer 333, and the fingerprint preventing layer 332 are substantially the same as those described in the surface treatment layer 330 of FIG. 7, and thus, to the extent that an element is not described in detail with respect to this figure, it may be understood that the element is at least similar to a corresponding element that has been described elsewhere within the present disclosure.

The high refractive index layer 334 may be arranged between the hard coating layer 331 and the low refractive index layer 333. The high refractive index layer 334 may include an organic material. The organic material may include one or more materials selected from the group consisting of polyethylene terephthalate, polyethylene naphthalate, polycarbonate, polyimide, polyethylene sulfonate, polyoxymethylene, polyarylate, hexamethyldisiloxane, an epoxy-based resin, and an acrylate-based resin (e.g., polymethyl methacrylate, polyacrylic acid, or the like). The high refractive index layer 334 may include a plurality of high refractive particles dispersed in an organic material. The high refractive particles may include metal oxide such as zirconium oxide, zinc oxide, titanium oxide, niobium oxide, tantalum oxide, tin oxide, nickel oxide, silicon nitride, indium nitride, gallium nitride, and the like. The high refractive index particles may be dispersed in a spherical or amorphous shape within the high refractive index layer 334.

As described above, the surface treatment layer 330 may obtain a low reflection effect by using an optical interference principle by combining the high refractive index layer 334 including a material having a high refractive index and the low refractive index layer 333 including a material having a low refractive index. For example, the surface treatment layer 330 may lower a surface reflectivity by light incident from the outside.

FIG. 9 is a cross-sectional view schematically illustrating an embodiment of the optical control module OCM of FIG. 6.

Referring to FIG. 9, an optical control module OCM-3 may include a phase difference layer 320, a first film layer 310, and a surface treatment layer 330.

Here, the first film layer 310 and the surface treatment layer 330 are substantially the same as the first film layer 310 and the surface treatment layer 330 described with reference FIG. 6 and the like, and thus, to the extent that an element is not described in detail with respect to this figure, it may be understood that the element is at least similar to a corresponding element that has been described elsewhere within the present disclosure.

According to the present embodiment, the phase difference layer 320 may include a λ/4 phase retardation layer 321 and a λ/2 phase retardation layer 322.

In an embodiment, the λ/2 phase retardation layer 322 may be arranged between the λ/4 phase retardation layer 321 and the first film layer 310.

The λ/2 phase retardation layer 322 may be an optical layer that delays a phase of provided light by λ/2. For example, in the case where a wavelength of light transmitted through the first film layer 310 and provided to the λ/2 phase retardation layer 322 is 550 nm, the light passing through the λ/2 phase retardation layer 322 may have a phase delay value of 275 nm. In some embodiments, a polarization state of light incident on the λ/2 phase retardation layer 322 may be changed. A polarization direction of linearly polarized light incident from the first film layer 310 to the λ/2 phase retardation layer 322 may be changed.

The λ/2 phase retardation layer 322 may be a liquid crystal coating layer. The λ/2 phase retardation layer 322 may be a liquid crystal coating layer manufactured by using a reactive liquid crystal monomer. The λ/2 phase retardation layer 322 may be manufactured through a process of coating, aligning, and then polymerizing a reactive liquid crystal monomer. For example, the liquid crystal monomer used in the λ/2 phase retardation layer 322 may have a disk-shaped discotic phase. For example, the λ/2 phase retardation layer 322 may be a discotic liquid crystal coating layer.

The λ/2 phase retardation layer 322 may include only a liquid crystal coating layer without a base substrate that is a support. A total thickness of the display device DD may be reduced by including, in the first film layer 310, the λ/2 phase retardation layer 322 including only the liquid crystal coating layer without including the base substrate. For example, a thickness of the first film layer 310 may be reduced by using the λ/2 phase retardation layer 322 that is the liquid crystal coating layer, and thus, a flexible display device may be more easily bent.

Both the λ/2 phase retardation layer 322 and the λ/4 phase retardation layer 321 may be phase retardation layers having normal wavelength dispersions but having different wavelength dispersions. However, the phase difference layer 320 in which the λ/2 phase retardation layer 322 and the λ/4 phase retardation layer 321 are combined may be the phase difference layer 320 having reverse wavelength dispersion. Therefore, the same effect as a single layer, which is the λ/4 phase retardation layer 321 having the reverse wavelength dispersion, may be obtained.

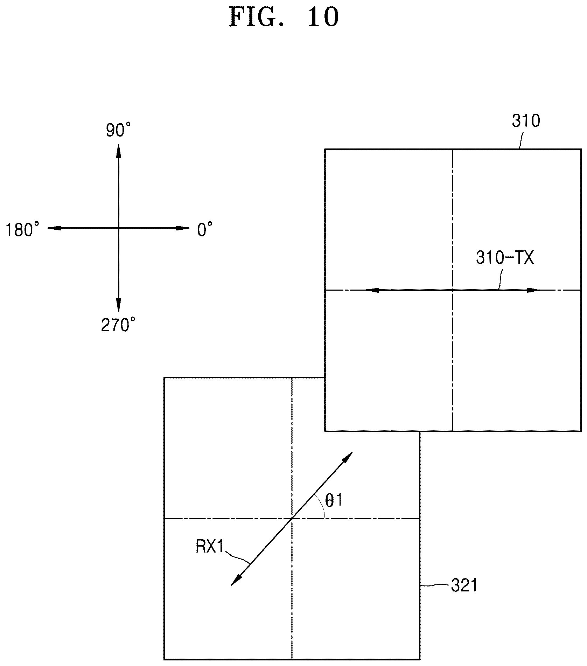

FIG. 10 is a view illustrating a relationship between optical axes in the display device DD according to an embodiment.

When a direction of a first optical axis 310-TX of a first film layer 310 is 0° and 180° and an angle between the first optical axis 310-TX of the first film layer 310 and a second optical axis RX1 of a λ/4 phase retardation layer 321 is θ1, the angle θ1 between the first optical axis 310-TX of the first film layer 310 and the second optical axis RX1 of the λ/4 phase retardation layer 321 may be 45 ± 5°. For example, the angle between the first optical axis 310-TX of the first film layer 310 and the second optical axis RX1 of the λ/4 phase retardation layer 321 may be 45°.

In some embodiments, in the case where the phase difference layer 320 further includes the λ/2 phase retardation layer 322, the angle between the second optical axis RX1 of the λ/4 phase retardation layer 321 and the first optical axis 310-TX of the first film layer 310 may be 75 ± 5°. In some embodiments, an angle between a third optical axis of the λ/2 phase retardation layer 322 and the second optical axis RX1 of the λ/4 phase retardation layer 321 may be 15 ± 5°. While the angular relationships may be within the ranges of 45 ± 5° and 15 ± 5° respectively, narrower sub-ranges may provide optimal performance. For example, the angle between the first optical axis 310-TX and the second optical axis RX1 may preferably be in a sub-range of 45 ± 2°. This tighter tolerance ensures a more ideal conversion between linear and circular polarization states, further enhancing the anti-reflection effect. Similarly, the angle between the second optical axis RX1 and the third optical axis of the λ/2 phase retardation layer 322 may preferably be in a sub-range of 15 ± 2° to achieve a more ideal broadband performance.

However, the embodiment is not necessarily limited thereto, and an arrangement of functional layers may be changed according to an image quality needed in an electronic device.

In an embodiment, the first film layer 310 may include a first dye that absorbs light in a preset wavelength band.

In an embodiment, the first dye may be a material that absorbs light in a blue wavelength band. For example, the first dye may be a blue coloring material such as a blue dye or a blue pigment. For example, the first dye may include a diazaporphyrin-based compound. Alternatively, the first dye may further include at least one dye selected from the group consisting of dyes of benzotriazole, tris-resorcinol-triazine, hydroxy-benzotriazole, and hydroxyphenyl-benzotriazole series. However, the first dye is not necessarily limited thereto, and may be included in the manufacture of the first film layer 310. For example, in the case where the first dye is added to the first film layer 310 in an unstretched state to uniaxially stretch the first film layer 310, an optical axis may be formed, and a film that selectively absorbs a particular wavelength band may be obtained.

In the case where the first film layer 310 is used in a display device according to an embodiment, circularly polarized light may be generated with respect to a blue wavelength, and thus, a reflectivity of the corresponding wavelength band may be lowered. Therefore, the display device, according to the present embodiment, may reduce both a surface bluish phenomenon and an internal bluish phenomenon, and thus, a bluish phenomenon that occurs when implementing a low reflection function may be improved.

In some embodiments, the first film layer 310 may further include a second dye that absorbs light in a wavelength band that is different from the wavelength band of the first dye. For example, the first film layer 310 may be manufactured by mixing one or more dyes.

For example, the second dye may include at least one dye selected from the group consisting of dyes of tetraazaporphyrin, cyanine, and squarine series.

The display device may further comprise a protective window layer WD, for example, an ultra-thin glass substrate, disposed over the display panel DP. The optical control module OCM may be positioned relative to this window layer WD in several ways. For instance, the entire optical control module OCM may be disposed on an outer surface of the window layer WD. Alternatively, the entire optical control module OCM may be disposed between the window layer WD and the display panel DP. In another embodiment, components of the optical control module OCM may be split, with some components disposed on the outer surface of the window layer WD and other components disposed between the window layer WD and the display panel DP.

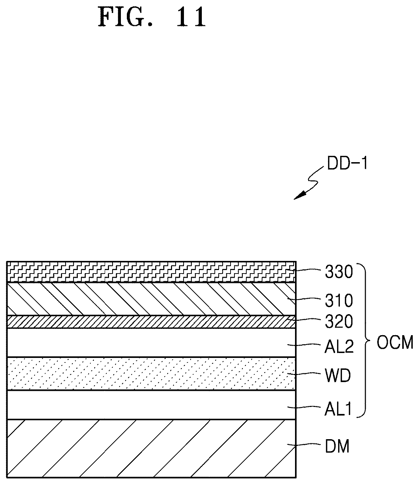

FIG. 11 is a cross-sectional view schematically illustrating a display device DD-1 according to an embodiment.

Referring to FIG. 11, an optical control module OCM may be disposed on a display module DM. In some embodiments, the optical control module OCM may include a first film layer 310, a phase difference layer 320, and a surface treatment layer 330.

The display device DD-1, according to the present embodiment, may further include a window layer WD, a first adhesive layer AL1, and a second adhesive layer AL2.

Here, the optical control module OCM may also be described as including the window layer WD, the first adhesive layer AL1, and the second adhesive layer AL2.

According to the present embodiment, the window layer WD may be arranged above the display module DM. In some embodiments, the first adhesive layer AL1, the window layer WD, and the second adhesive layer AL2 may be sequentially stacked and arranged in the third direction DR3. For example, the first adhesive layer AL1 may be arranged between the display module DM and the window layer WD to attach the window layer WD onto the display module DM.

Here, the first adhesive layer AL1 may be a pressure sensitive adhesive (PSA) film or an optically clear adhesive (OCA). The PSA may include a polymer curing agent. The PSA may include an acrylate-based or rubber-based adhesive, or an adhesive containing particulates such as Zirconia in the adhesive. Alternatively, the first adhesive layer AL1 may include an optically clear resin (OCR) or the like.

Here, the window layer WD may cover the entire upper surface of the display module DM. The window layer WD may have a shape corresponding to a shape of the display module DM.

The window layer WD may include an optically transparent insulating material. The window layer WD may be a glass substrate or a polymer substrate. For example, the window layer WD may be a tempered glass substrate. In some embodiments, the window layer WD may have a thickness that is small enough to enable a folding operation. The window layer WD may be an ultra-thin glass (UTG) substrate. The window layer WD may include a glass material and may be used as a cover window in an electronic device.

In some embodiments, the phase difference layer 320, the first film layer 310, and the surface treatment layer 330 may be arranged above the window layer WD. In some embodiments, the phase difference layer 320, the first film layer 310, and the surface treatment layer 330 may be sequentially stacked and arranged in the third direction DR3.

The second adhesive layer AL2 may be arranged between the window layer WD and the phase difference layer 320 to attach the first film layer 310 including the phase difference layer 320 onto the window layer WD.

For example, the window layer WD may be attached to the display module DM through the first adhesive layer AL1 below the window layer WD, and may be attached to the phase difference layer 320 and the first film layer 310 above the window layer WD through the second adhesive layer AL2.

Here, the second adhesive layer AL2 may be a PSA film or an OCA. The PSA may include a polymer curing agent. The PSA may include an acrylate-based or rubber-based adhesive, or an adhesive containing particulates such as zirconia in the adhesive. Alternatively, the second adhesive layer AL2 may include an OCR or the like.

Here, the first film layer 310, the phase difference layer 320, and the surface treatment layer 330 may be the first film layer 310, the phase difference layer 320, and the surface treatment layer 330 described above with reference to FIG. 6 and the like.

Although the surface treatment layer 330 is illustrated as a schematic example in FIG. 11, the surface treatment layer 330 may include the hard coating layer 331, and may further include one or more of the low refractive index layer 333 and the high refractive index layer 334. In some embodiments, the surface treatment layer 330 may include the fingerprint preventing layer 332 on the outermost layer.

In some embodiments, although the phase difference layer 320 is illustrated as a schematic example in FIG. 11, the phase retardation layer may be the phase difference layer 320 described above with reference to FIG. 6 and the like. For example, the phase difference layer 320 may be the λ/4 phase retardation layer 321, and may have a multilayer structure in which the λ/4 phase retardation layer 321 and the λ/2 phase retardation layer 322 are combined.

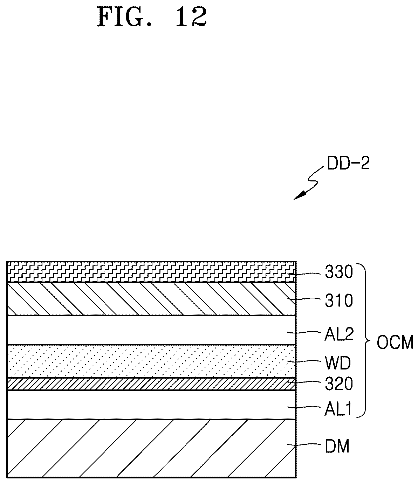

FIG. 12 is a cross-sectional view schematically illustrating a display device DD-2 according to an embodiment.

Referring to FIG. 12, the display device DD-2, according to an embodiment, may include a display module DM and an optical control module OCM.

Here, the display module DM is substantially the same as the display module DM described with reference to FIG. 5 and the like, and thus, to the extent that an element is not described in detail with respect to this figure, it may be understood that the element is at least similar to a corresponding element that has been described elsewhere within the present disclosure.

In some embodiments, the optical control module OCM may include a first film layer 310, a phase difference layer 320, and a surface treatment layer 330, and may further include a window layer WD, a first adhesive layer AL1, and a second adhesive layer AL2.

Here, the first film layer 310, the phase difference layer 320, the surface treatment layer 330, the window layer WD, the first adhesive layer AL1, and the second adhesive layer AL2 are substantially the same as those described in the display device DD-1 of FIG. 11, and thus, to the extent that an element is not described in detail with respect to this figure, it may be understood that the element is at least similar to a corresponding element that has been described elsewhere within the present disclosure.

However, the display device DD-2 according to the present embodiment may be different from the display device DD-1 according to the embodiment illustrated in FIG. 11 in a stack structure.

According to the present embodiment, the phase difference layer 320 may be arranged below the window layer WD.

For example, the first adhesive layer AL1 may be disposed on the display module DM, and the window layer WD may be disposed above the first adhesive layer AL1. Here, the phase difference layer 320 may be arranged between the first adhesive layer AL1 and the window layer WD. To describe the above example from another perspective, the first adhesive layer AL1 may attach the phase difference layer 320 to the display module DM.

In some embodiments, the second adhesive layer AL2 may be disposed on the window layer WD. The first film layer 310 may be disposed on the second adhesive layer AL2, and the surface treatment layer 330 may be disposed on the first film layer 310.

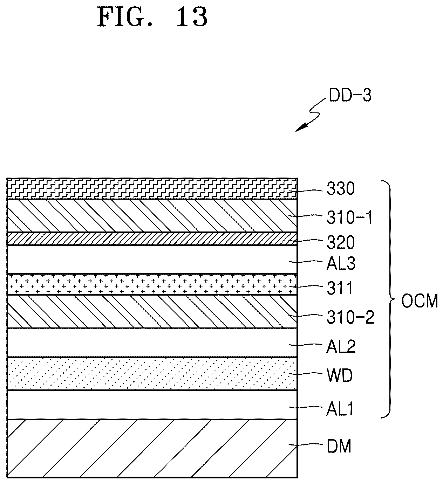

FIG. 13 is a cross-sectional view schematically illustrating a display device DD-3 according to an embodiment.

Referring to FIG. 13, the display device DD-3, according to an embodiment, may include a display module DM and an optical control module OCM.

Here, the display module DM is substantially the same as the display module DM described with reference to FIG. 5 and the like, and thus, to the extent that an element is not described in detail with respect to this figure, it may be understood that the element is at least similar to a corresponding element that has been described elsewhere within the present disclosure.

In some embodiments, the optical control module OCM may include a first film layer 310-1, a phase difference layer 320, and a surface treatment layer 330, and may further include a window layer WD, a first adhesive layer AL1, and a second adhesive layer AL2.

Here, the first film layer 310-1, the phase difference layer 320, the surface treatment layer 330, the window layer WD, the first adhesive layer AL1, and the second adhesive layer AL2 are substantially the same as those described in the display device DD-1 of FIG. 11, and thus, to the extent that an element is not described in detail with respect to this figure, it may be understood that the element is at least similar to a corresponding element that has been described elsewhere within the present disclosure.

However, the display device DD-3, according to the present embodiment, may be different from the display device DD-1 according to the embodiment illustrated in FIG. 11 in a stack structure.

In some embodiments, the optical control module OCM, according to the present embodiment, may further include a second film layer 310-2.

Here, the second film layer 310-2 might not include an optical axis. For example, the optical control module OCM may further include the second film layer 310-2 that does not include the optical axis.

The second film layer 310-2 may be arranged under the first film layer 310-1. In some embodiments, the second film layer 310-2 may be arranged between the first film layer 310-1 and the window layer WD.

In some embodiments, the first adhesive layer AL1, the window layer WD, the window layer WD, and the second adhesive layer AL2 may be sequentially stacked and disposed on the display module DM in the third direction DR3, and the second film layer 310-2 may be disposed on the second adhesive layer AL2.

Here, a coating layer 311 may be disposed on the second film layer 310-2. In some embodiments, the coating layer 311 may include a hard coating layer.

In some embodiments, a third adhesive layer AL3 may be disposed on the coating layer 311. The third adhesive layer AL3 may be arranged between the coating layer 311 and the phase difference layer 320 to attach the first film layer 310-1 including the phase difference layer 320 to the coating layer 311.

Here, the third adhesive layer AL3 may include a PSA film, an OCA, an OCR, or the like.

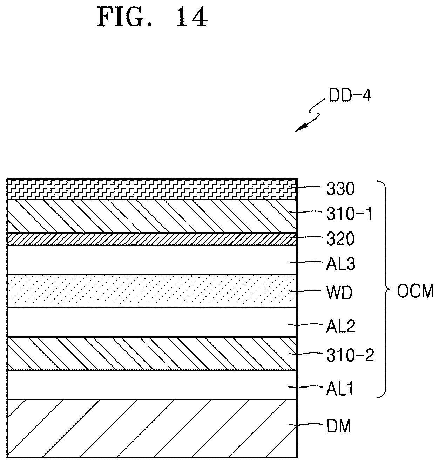

FIG. 14 is a cross-sectional view schematically illustrating a display device DD-4 according to an embodiment.

Referring to FIG. 14, the display device DD-4, according to an embodiment, may include a display module DM and an optical control module OCM.

Here, the display module DM is substantially the same as the display module DM described with reference FIG. 5 and the like, and thus, to the extent that an element is not described in detail with respect to this figure, it may be understood that the element is at least similar to a corresponding element that has been described elsewhere within the present disclosure.

**In** some embodiments, the optical control module OCM may include a first film layer 310-1, a phase difference layer 320, and a surface treatment layer 330, and may further include a window layer WD, a second film layer 310-2, a first adhesive layer AL1, a second adhesive layer AL2, and a third adhesive layer AL3.

Here, the first film layer 310-1, the phase difference layer 320, the surface treatment layer 330, the window layer WD, the second film layer 310-2, the first adhesive layer AL1, the second adhesive layer AL2, and the third adhesive layer AL3 are substantially the same as those described in the display device DD-3 of FIG. 13, and thus, to the extent that an element is not described in detail with respect to this figure, it may be understood that the element is at least similar to a corresponding element that has been described elsewhere within the present disclosure.

However, the display device DD-4, according to the present embodiment, may be different from the display device DD-3 according to the embodiment illustrated in FIG. 13 in a stack structure.

The second film layer 310-2 may be arranged under the first film layer 310-1. In some embodiments, the second film layer 310-2 may be arranged under the window layer WD.

To describe the above example from another perspective, the window layer WD may be arranged between the first film layer 310-1 and the second film layer 310-2.

The second film layer 310-2 may be arranged above the display module DM, and the first adhesive layer AL1, the second film layer 310-2, and the second adhesive layer AL2 may be sequentially stacked and arranged in the third direction DR3.

In some embodiments, the window layer WD may be disposed on the second adhesive layer AL2. In some embodiments, the second adhesive layer AL2, the window layer WD, and the third adhesive layer AL3 may be sequentially stacked and arranged in the third direction DR3.

In some embodiments, the phase difference layer 320, the first film layer 310-1, and the surface treatment layer 330 may be sequentially stacked and disposed on the third adhesive layer AL3 in the third direction DR3.

For example, the third adhesive layer AL3 may be arranged between the window layer WD and the phase difference layer 320 to attach the first film layer 310-1 including the phase difference layer 320 to the window layer WD.

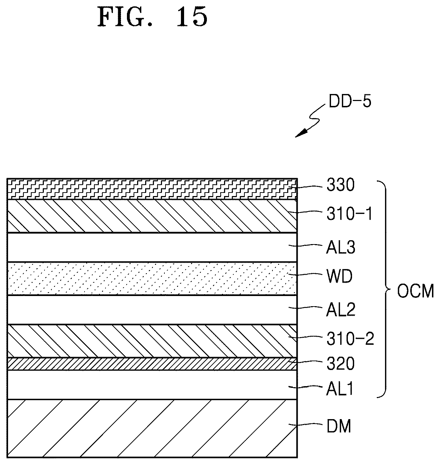

FIG. 15 is a cross-sectional view schematically illustrating a display device DD-5 according to an embodiment.

Referring to FIG. 15, a display device DD-5, according to an embodiment, may include a display module DM and an optical control module OCM.

Here, the display module DM is substantially the same as the display module DM described with reference to FIG. 5 and the like, and thus, to the extent that an element is not described in detail with respect to this figure, it may be understood that the element is at least similar to a corresponding element that has been described elsewhere within the present disclosure.

In some embodiments, the optical control module OCM may include a first film layer 310-1, a phase difference layer 320, and a surface treatment layer 330, and may further include a window layer WD, a second film layer 310-2, a first adhesive layer AL1, a second adhesive layer AL2, and a third adhesive layer AL3.

Here, the first film layer 310-1, the phase difference layer 320, the surface treatment layer 330, the window layer WD, the second film layer 310-2, the first adhesive layer AL1, the second adhesive layer AL2, and the third adhesive layer AL3 are substantially the same as those described in the display device DD-3 of FIG. 13, and thus, to the extent that an element is not described in detail with respect to this figure, it may be understood that the element is at least similar to a corresponding element that has been described elsewhere within the present disclosure.

However, the display device DD-5 according to the present embodiment may be different from the display device DD-3 according to the embodiment illustrated in FIG. 13 in a stack structure.

The second film layer 310-2 may be arranged under the first film layer 310-1. In some embodiments, the second film layer 310-2 may be arranged under the window layer WD.

To describe the above example from another perspective, the window layer WD may be arranged between the first film layer 310-1 and the second film layer 310-2.

In some embodiments, the phase difference layer 320 may be arranged below the second film layer 310-2. To describe the above example from another perspective, the phase difference layer 320 might not be directly combined with the first film layer 310-1 but may be spaced apart from the first film layer 310-1.

To describe the above example from another perspective, the phase difference layer 320 may be disposed directly on a film that does not include an optical axis.

In some embodiments, the first adhesive layer AL1, the phase difference layer 320, and the second film layer 310-2 may be sequentially disposed on the display module DM in the third direction DR3.

For example, the first adhesive layer AL1 may attach the second film layer 310-2 including the phase difference layer 320 to the display module DM.

In some embodiments, the second adhesive layer AL2 may be disposed on the second film layer 310-2, and the window layer WD may be disposed on the second adhesive layer AL2.

In some embodiments, the second adhesive layer AL2, the window layer WD, and the third adhesive layer AL3 may be sequentially stacked and arranged in the third direction DR3.

In some embodiments, the first film layer 310-1 and the surface treatment layer 330 may be sequentially stacked and disposed on the third adhesive layer AL3 in the third direction DR3.

For example, the third adhesive layer AL3 may be arranged between the window layer WD and the first film layer 310-1 to attach the first film layer 310-1 to the window layer WD.

However, the first adhesive layer AL1, the second adhesive layer AL2, and the third adhesive layer AL3 may be omitted from the optical control module OCM.

In some embodiments, although not illustrated in FIG. 15, the display device DD, according to an embodiment, may have a structure in which locations of the first film layer 310-1 and the second film layer 310-2 are exchanged with each other in the display device DD-5 of FIG. 15.

For example, the first film layer 310-1 may be arranged under the second film layer 310-2, and the phase difference layer 320 may be arranged under the first film layer 310-1.

In some embodiments, the second adhesive layer AL2, the window layer WD, and the third adhesive layer AL3 may be sequentially disposed on the first film layer 310-1 in the third direction DR3. In some embodiments, the second film layer 310-2 and the surface treatment layer 330 may be sequentially disposed on the third adhesive layer AL3.

To describe the above example from another perspective, the first film layer 310-1 and the phase difference layer 320 may be arranged under the window layer WD. For example, a film including an optical axis, and the phase difference layer 320 may be arranged closer to the display module DM than the window layer WD.

Table 1 shows the results of measuring a reflectivity of a display device according to an embodiment and a reflectivity of a display device according to a comparative example.

In the display device according to the comparative example, a polarizer may be removed, a film in which a difference between a modulus in an MD and a modulus in a TD is less than 0.5 Gpa may be applied, and a phase difference layer might not be applied. In embodiment 1, a polarizer may be removed, and a λ/4 phase retardation layer may be applied to a PET film uniaxially stretched in a TD. In embodiment 2, a polarizer may be removed, and a λ/4 phase retardation layer may be applied to a PET film uniaxially stretched in a TD. In addition, in embodiment 2, an angle between an optical axis of the λ/4 phase retardation layer and an optical axis of a first film layer may be aligned to about 45°.

The reflectivity and a reflective color may be expressed by measuring reflectivity % and color shift values of color coordinates a* and b* on the basis of specular component included (SCI) and specular component excluded (SCE) reflection.

**[Table 1]**

| | | Comparative Example | Embodiment 1 | Embodiment 2 |
|---|---|---|---|---|
| SCI | Reflectivity (%) | 6.0 | 5.3 | 5.0 |
| | a* | -0.4 | 1.1 | 0.7 |
| | b* | -2.5 | -4.3 | -3.8 |
| SCE | Reflectivity (%) | 0.7 | 0.9 | 0.7 |
| | a* | -0.6 | -0.2 | 0.2 |
| | b* | -3.4 | -5.5 | -4.8 |

Referring to the results in Table 1, the reflectivity in embodiment 1 is 0.7 lower than the reflectivity in the comparative example. The reflectivity in embodiment 2 is 1.0 lower than the reflectivity in the comparative example. Accordingly, in the case where the λ/4 phase retardation layer is applied to the film uniaxially stretched in the TD, the reflectivity may be reduced compared to the case where only a uniaxially unstretched film is applied.

In some embodiments, in the case where an angle between an optical axis of the film uniaxially stretched in the TD and the optical axis of the λ/4 phase retardation layer is aligned to about 45°, the reflectivity may be reduced compared to the case where the optical axis is not aligned.

As described above, the display device DD, according to an embodiment, may reduce an internal reflectivity in an OCF structure in which the light blocking pattern BM and the color filter CF are applied instead of the polarizer. In some embodiments, the total reflectivity of the display device DD may be reduced by reducing a surface reflectivity through a surface treatment layer of the outermost film.

As described above, display devices, according to the disclosure, may be applied to various fields, and the detailed description thereof is given below.

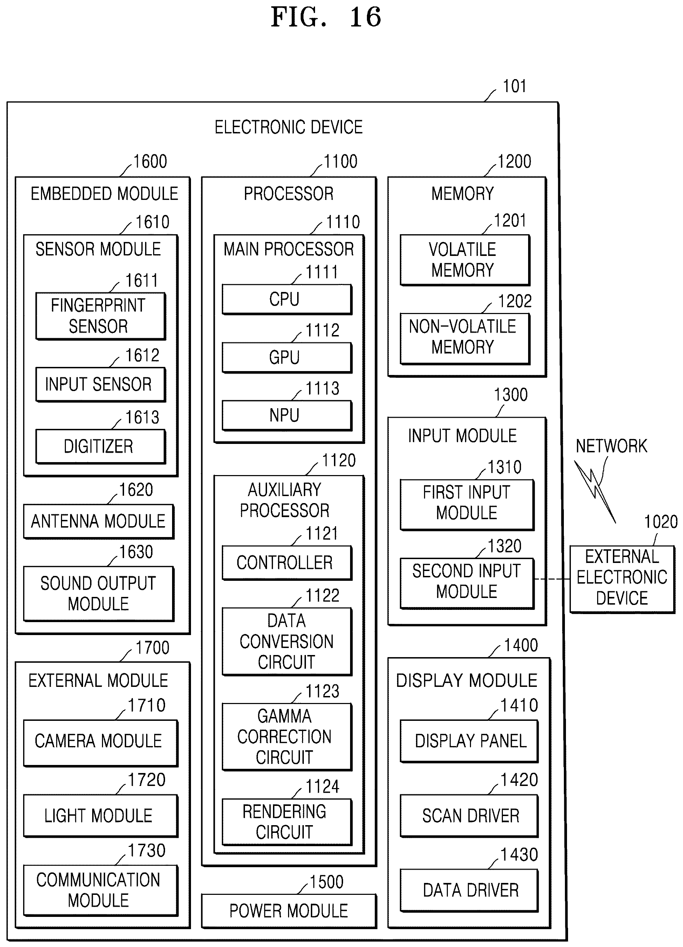

FIG. 16 is a block diagram of an electronic device according to an embodiment. FIG. 16 illustrates that an electronic device 101 as an example may selectively include one or more or a plurality of components from among a plurality of components illustrated in FIG. 16 according to use and design conditions of the electronic device 101.

The electronic device 101 may output various types of information through a display module 1400 within an operating system. The display module 1400 may correspond to the display device DD, DD-1, DD-2, DD-3, DD4, or DD-5, or the display module DM according to the embodiment described above or may correspond to at least a partial area thereof.

In the case where a processor 1100 executes an application stored in a memory 1200, the display module 1400 may provide application information to a user through a display panel 1410.

The processor 1100 may acquire an external input through an input module 1300 or a sensor module 1610 and execute an application corresponding to the external input. For example, in the case where the user selects a camera icon displayed on the display panel 1410, the processor 1100 may acquire a user input through an input sensor 1612 and activate a camera module 1710. The processor 1100 may transmit, to the display module 1400, image data corresponding to a captured image acquired through the camera module 1710. The display module 1400 may display an image corresponding to the captured image through the display panel 1410.

As an example, in the case where personal information authentication is performed in the display module 1400, a fingerprint sensor 1611 may acquire input fingerprint information as input data. The processor 1100 may compare the input data acquired through the fingerprint sensor 1611 with authentication data stored in the memory 1200 and execute the application according to the result of the comparison. The display module 1400 may display, through the display panel 1410, information executed according to logic of the application.

As an example, in the case where a music streaming icon displayed on the display module 1400 is selected, the processor 1100 may acquire a user input through the input sensor 1612 and activate a music streaming application stored in the memory 1200. In the case where a music execution command is input from the music streaming application, the processor 1100 may activate a sound output module 1630 to provide the user with sound information corresponding to the music execution command.

The operation of the electronic device 101 is briefly described above. Hereinafter, components of the electronic device 101 are described in detail. Some of the components of the electronic device 101 described below may be integrated and provided as one component, and one component may be separated into two or more components and provided.

Referring to FIG. 16, the electronic device 101 may also communicate with an external electronic device 1020 via a network (e.g., a short-range wireless communication network or a long-range wireless communication network). According to an embodiment, the electronic device 101 may include the processor 1100, the memory 1200, the input module 1300, the display module 1400, a power module 1500, an internal module 1600, or an external module 1700. According to an embodiment, the electronic device 101 may have at least one of the above-described components omitted, or one or more other components added. In some embodiments, according to an embodiment, some of the components described above (e.g., the sensor module 1610, an antenna module 1620, or the sound output module 1630) may be integrated into another component (e.g., the display module 1400).

The processor 1100 may execute software to control at least one other component (e.g., a hardware or software component) of the electronic device 101 connected to the processor 1100 and perform various types of data processing or operations. According to an embodiment, as at least some of data processing or operations, the processor 1100 may store a command or data received from another component (e.g., the input module 1300, the sensor module 1610, or a communication module 1730) in a volatile memory 1201, process the command or data stored in the volatile memory 1201, and store result data in a nonvolatile memory 1202.

The processor 1100 may include a main processor 1110 and an auxiliary processor 1120. The main processor 1110 may include one or more of a central processing unit (CPU) 1111 and an application processor (AP). The main processor 1110 may further include one or more of a graphic processing unit (GPU) 1112, a communication processor (CP), and an image signal processor (ISP). The main processor 1110 may further include a neural processing unit (NPU) 1113. The NPU 1113 may be a processor particularized in processing by an artificial intelligence model, and the artificial intelligence model may be created through machine learning. The artificial intelligence model may include a plurality of artificial neural network layers. An artificial neural network may be one of a deep neural network (DNN), a convolutional neural network (CNN), a recurrent neural network (RNN), a restricted boltzmann machine (RBM), a deep belief network (DBN), a bidirectional recurrent deep neural network (BRDNN), a deep Q-network, and a combination of two or more of the above examples, but is not necessarily limited to the examples described above. The artificial intelligence model may additionally or alternatively include a software structure in addition to a hardware structure. At least two of the processing unit and the processor described above may be implemented as a single integrated component (e.g., a single chip) or may each be implemented as an independent component (e.g., a plurality of chips).

The auxiliary processor 1120 may include a controller 1121. The controller 1121 may include an interface conversion circuit and a timing control circuit. The controller 1121 may receive an image signal from the main processor 1110, convert a data format of the image signal to match interface specifications with the display module 1400, and output image data. The controller 1121 may output various types of control signals needed for driving the display module 1400.

The auxiliary processor 1120 may further include the controller 1121, a data conversion circuit 1122, a gamma correction circuit 1123, a rendering circuit 1124, and the like. The data conversion circuit 1122 may receive image data from the controller 1121 and compensate for the image data so that an image is displayed at desired luminance according to characteristics of the electronic device 101 or setting by the user, or convert the image data for a reduction in power consumption, compensation for an afterimage, or the like. The gamma correction circuit 1123 may convert the image data, a gamma reference voltage, or the like so that the image displayed on the electronic device 101 has desired gamma characteristics. The rendering circuit 1124 may receive the image data from the controller 1121 and render the image data by considering an arrangement of pixels of the display panel 1410 applied to the electronic device 101, or the like. At least one of the data conversion circuit 1122, the gamma correction circuit 1123, and the rendering circuit 1124 may be integrated into another component (e.g., the main processor 1110 or the controller 1121). At least one of the data conversion circuit 1122, the gamma correction circuit 1123, and the rendering circuit 1124 may also be integrated into a data driver 1430 described below.

The memory 1200 may store various types of data used by at least one component of the electronic device 101 (e.g., the processor 1100 or the sensor module 1610), and input or output data for commands related to the same. The memory 1200 may include at least one of the volatile memory 1201 and the nonvolatile memory 1202.

The input module 1300 may receive a command or data to be used in a component of the electronic device 101 (e.g., the processor 1100, the sensor module 1610, or the sound output module 1630) from the outside of the electronic device 101 (e.g., the user or the external electronic device 1020).

The input module 1300 may include a first input module 1310 into which a command or data is input from the user and a second input module 1320 into which a command or data is input from the external electronic device 1020. The first input module 1310 may include a microphone, a mouse, a keyboard, a key (e.g., a button) or a stylus/pen (e.g., a passive stylus/pen or an active stylus/pen). The second input module 1320 may support a designated protocol that enables a connection to the external electronic device 1020 by wired or wirelessly. According to an embodiment, the second input module 1320 may include a high definition multimedia interface (HDMI), a universal serial bus (USB) interface, a secure digital (SD) card interface, or an audio interface. The second input module 1320 may include a connector that enables a physical connection to the external electronic device 1020, e.g., an HDMI connector, a USB connector, an SD card connector, or an audio connector (e.g., a headphone connector).

The display module 1400 may visually provide information to the user. The display module 1400 may include the display panel 1410, a scan driver 1420, and the data driver 1430.

The display module 1400, the display panel 1410, or the like described with reference to FIG. 16 may correspond to the display module DM or the display panel DP according to the embodiment described above.

The display panel 1410 may further include a light-emitting driver. The light-emitting driver may output a light-emitting control signal to the display panel 1410 in response to a control signal received from the controller 1121. The light-emitting driver may be formed separately from the scan driver 1420, or may be integrated into the scan driver 1420.

The scan driver 1420 may receive the control signal from the controller 1121, and output scan signals to the display panel 1410 in response to the control signal.

The data driver 1430 may receive the control signal from the controller 1121, convert the image data into an analog voltage (e.g., a data voltage) in response to the control signal, and output data voltages to the display panel 1410.

The data driver 1430 may be integrated into another component (e.g., the controller 1121). Functions of the interface conversion circuit and the timing control circuit of the controller 1121 described above may also be integrated into the data driver 1430.

The display module 1400 may further include the light-emitting driver, a voltage generation circuit, and the like. The voltage generation circuit may output various types of voltages needed for driving the display panel 1410.

The power module 1500 may supply power to the components of the electronic device 101. For example, the power module 1500 may generate a first voltage ELVDD (refer to FIG. 2) and a second voltage ELVSS (refer to FIG. 2). The power module 1500 may generate a gate driving voltage (e.g., a gate high voltage or a gate low voltage) needed for driving the scan driver 1420.

For example, the power module 1500 may refer to a power generator, a power supply, or the like. As a detailed example, the power module 1500 may include a battery that charges a power voltage. The battery may include a non-rechargeable primary battery, a rechargeable secondary battery, or a fuel cell.

For example, the power module 1500 may include a power management integrated circuit (PMIC). The PMIC may supply optimized power to each of the modules described above and modules described below.

For example, the power module 1500 may include a wireless power transceiver electrically connected to the battery. The wireless power transceiver may include a plurality of antenna radiators having a coil shape.

The electronic device 101 may further include the internal module 1600 and the external module 1700. The internal module 1600 may include the sensor module 1610, the antenna module 1620, and the sound output module 1630. The external module 1700 may include the camera module 1710, a light module 1720, and a communication module 1730.

The sensor module 1610 may detect an input by the body of the user or an input by the stylus/pen from among the first input module 1310 and generate an electrical signal or a data value corresponding to the input. The sensor module 1610 may include at least one of the fingerprint sensor 1611, the input sensor 1612, and a digitizer 1613.

The fingerprint sensor 1611 may generate a data value corresponding to a fingerprint of the user. The fingerprint sensor 1611 may include any one of an optical type or capacitive type fingerprint sensor.

The input sensor 1612 may generate a data value corresponding to coordinate information of the input by the body of the user or the input by the pen. The input sensor 1612 may generate, as a data value, a capacitance variation by an input. **In** some embodiments, the input sensor 1612 may detect the input by the passive stylus/pen or transmit and receive data to and from the active stylus/pen.

The input sensor 1612 may measure a bio-signal such as blood pressure, moisture, or body fat. For example, in the case where the user touches a sensor layer or sensing panel with a body part and does not move for a certain period of time, the input sensor 1612 may detect a bio-signal and output information desired by the user to the display module 1400, on the basis of a change in an electric field by the body part.

The digitizer 1613 may generate a data value corresponding to the coordinate information of the input by the pen. The digitizer 1613 may generate, as a data value, an electromagnetic variation caused by an input. The digitizer 1613 may detect the input by the passive stylus/pen or transmit and receive data to and from the active stylus/pen.

At least one of the fingerprint sensor 1611, the input sensor 1612, and the digitizer 1613 may be implemented as a sensor layer formed on the display panel 1410 through a continuous process. The fingerprint sensor 1611, the input sensor 1612, and the digitizer 1613 may be disposed on the display panel 1410, and any one of the fingerprint sensor 1611, the input sensor 1612, and the digitizer 1613, e.g., the digitizer 1613, may be disposed below the display panel 1410.

At least two of the fingerprint sensor 1611, the input sensor 1612, and the digitizer 1613 may be integrated into one sensing panel through the same process. In some embodiments, in the case where at least two of the fingerprint sensor 1611, the input sensor 1612, and the digitizer 1613 are integrated into one sensing panel, the sensing panel may be disposed on the display panel 1410 and as an example, may also be disposed on a window portion disposed on the display panel 1410, and a location of the sensing panel may be variously determined by controlling conditions of other manufacturing processes.

As a selective embodiment, at least one of the fingerprint sensor 1611, the input sensor 1612, and the digitizer 1613 may be embedded in the display panel 1410. For example, at least one of the fingerprint sensor 1611, the input sensor 1612, and the digitizer 1613 may be simultaneously formed through a process of forming devices (e.g., a light-emitting device, a transistor, and the like) included in the display panel 1410.

**In** some embodiments, the sensor module 1610 may generate an electrical signal or a data value corresponding to an internal state or an external state of the electronic device 101. The sensor module 1610 may further include, for example, a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The antenna module 1620 may include one or more antennas for transmitting or receiving a signal or power to or from the outside. According to an embodiment, the communication module 1730 may transmit or receive a signal to or from an external electronic device through an antenna appropriate for a communication method. An antenna pattern of the antenna module 1620 may be integrated into one component of the display module 1400 (e.g., the display panel 1410) or the input sensor 1612.

The sound output module 1630 may be a device for outputting a sound signal to the outside of the electronic device 101, and may include, for example, a speaker used for a general purpose, such as multimedia playback or recording playback, and a receiver used exclusively for phone reception. According to an embodiment, the receiver may be formed integrally with or separately from the speaker. A sound output pattern of the sound output module 1630 may be integrated into the display module 1400.

The camera module 1710 may capture a still image and a moving image. According to an embodiment, the camera module 1710 may include one or more lenses, an image sensor, or an image signal processor. The camera module 1710 may further include an infrared camera capable of measuring the presence or absence of the user, a location of the user, a gaze of the user, and the like.

The light module 1720 may provide light. The light module 1720 may include a light-emitting diode or a xenon lamp. The light module 1720 may operate in conjunction with the camera module 1710 or independently.

The communication module 1730 may support establishment of a wired or wireless communication channel between the electronic device 101 and the external electronic device 1020, and performance of communication through the established communication channel. The communication module 1730 may include any one or both of a wireless communication module such as a cellular communication module, a short-range wireless communication module, or a global navigation satellite system (GNSS) communication module and a wired communication module such as a local area network (LAN) communication module or a power line communication module. The communication module 1730 may communicate with the external electronic device 1020 over a short-range communication network such as Bluetooth, Wi-Fi direct, or infrared data association (IrDA) or a long-range communication network such as a cellular network, the Internet, or a computer network (e.g., a LAN or a WAN). Various types of communication modules 1730 described above may be implemented as a single chip or may be implemented as separate chips.

The input module 1300, the sensor module 1610, the camera module 1710, and the like may be used to control an operation of the display module 1400 in conjunction with the processor 1100.

The processor 1100 may output a command or data to the display module 1400, the sound output module 1630, the camera module 1710, or the light module 1720 on the basis of the input data received from the input module 1300. For example, the processor 1100 may generate image data in response to input data applied through the mouse or the active stylus/pen and output the image data to the display module 1400, or may generate command data in response to input data and output the command data to the camera module 1710 or the light module 1720. In the case where input data is not received from the input module 1300 for a certain time, the processor 1100 may reduce power consumed by the electronic device 101 by switching an operation mode of the electronic device 101 to a low power mode or a sleep mode.

The processor 1100 may output the command or data to the display module 1400, the sound output module 1630, the camera module 1710, or the light module 1720 on the basis of sensing data received from the sensor module 1610. For example, the processor 1100 may compare authentication data applied by the fingerprint sensor 1611 with authentication data stored in the memory 1200, and then execute the application according to the result of the comparison. The processor 1100 may execute a command or output corresponding image data to the display module 1400 on the basis of sensing data detected by the input sensor 1612 or the digitizer 1613. In the case where the sensor module 1610 includes a temperature sensor, the processor 1100 may receive temperature data regarding a measured temperature from the sensor module 1610 and further perform luminance correction or the like on the image data on the basis of the temperature data.

The processor 1100 may receive measurement data regarding the presence or absence of the user, the location of the user, the gaze of the user, and the like from the camera module 1710. The processor 1100 may further perform luminance correction and the like on the image data on the basis of the measured data. For example, the processor 1100, which determines the presence or absence of the user through an input from the camera module 1710, may output the image data having the corrected luminance to the display module 1400 through the data conversion circuit 1122 or the gamma correction circuit 1123.

Some of the above components may be connected to each other through a communication method between peripheral devices, e.g., a bus, a general-purpose input/output (GPIO), serial peripheral interface (SPI), mobile industry processor interface (MIPI), or ultra path interconnect (UPI) link to exchange a signal (e.g., a command or data) with each other. The processor 1100 may communicate with the display module 1400 through an interface promised to each other, e.g., may use any one of the above-described communication methods, and is not necessarily limited to the above-described communication methods.

The electronic device 101, according to various embodiments provided herein, may be various types of devices. The electronic device 101 may include, for example, at least one of a portable communication device (e.g., a smartphone), a computer device, a portable multimedia device, a portable medical device, a camera, a wearable device, and a home appliance. The electronic device 101, according to an embodiment, is not necessarily limited to the devices described above.

An example implementation of the electronic device 101 is described in detail.

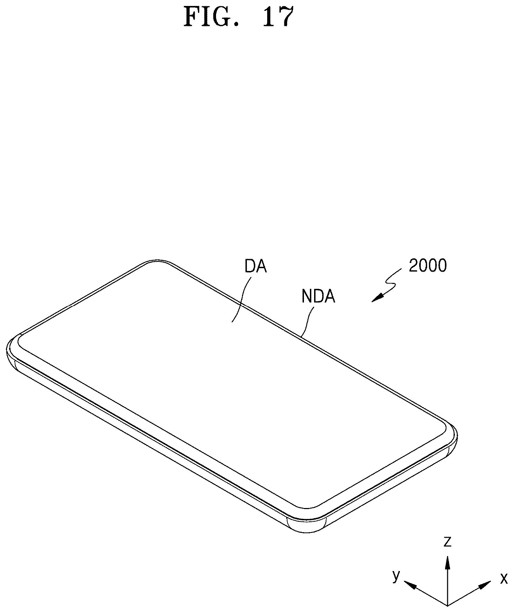

FIG. 17 is a view illustrating an electronic device to which a display device according to an embodiment is applied.

The display device described above, e.g., the display device DD, DD-1, DD-2, DD-3, DD4, or DD-5, may be easily applied to various types of electronic devices.

For example, the display devices DD, DD-1, DD-2, DD-3, DD4, and DD-5 according to the embodiments described above may be various types of products or some thereof, such as a television, a laptop computer, a computer monitor, a digital billboard, and Internet of things (IOT) device, as well as portable electronic device such as a mobile phone, a smart phone, a tablet computer, a mobile communication terminal, an electronic notebook, an electronic book, a portable multimedia player (PMP) or a navigation system, or an ultra mobile PC (UMPC).

In some embodiments, the display devices DD, DD-1, DD-2, DD-3, DD-4, and DD-5 according to the embodiments described above may each be a wearable device or a portion thereof, such as a smart watch, a watch phone, a glasses-type display, or a head mounted display (HMD).

The disclosure is not necessarily limited thereto. For example, the display devices DD, DD-1, DD-2, DD-3, DD4, and DD-5 according to the embodiments described above may each be included in a CID arranged on an instrument panel of a vehicle, and a center fascia or dashboard of the vehicle, a display replacing a side mirror of the vehicle, a display arranged for the rear seat entertainment of the vehicle or on the rear side of a front seat, a head up display (HUD) installed at the front of the vehicle or projected on a front window glass, and a computer generated hologram augmented reality head up display (CGH AR HUD).

For example, FIG. 17 illustrates that an electronic device 2000 to which the display device DD, DD-1, DD-2, DD-3, DD4, or DD-5 according to the embodiments described above is applied is a smartphone.

The electronic device 2000 may include a display area DA and a non-display area NDA beyond (e.g., surrounding) the display area DA. The display area DA may overlap the display area DA of the display device 200 described above, or as an example, may include a shape partially covered. The non-display area NDA of the electronic device 2000 may be an area that does not display an image, and may be an area that overlaps in whole or in part with the non-display area NDA of the display device 200. In the non-display area NDA of the electronic device 2000, a driver or the like for providing an electrical signal or power to display devices arranged in the display area DA may be arranged, and a pad, which is an area in which an electronic device, a printed circuit board, or the like may be electrically connected, may be arranged. The electronic device 2000, which is a smartphone, may be of a rigid type, or may include various types, such as a bending type in which one side or both sides are bent, and a foldable type in which the device is folded more than once, as an example.

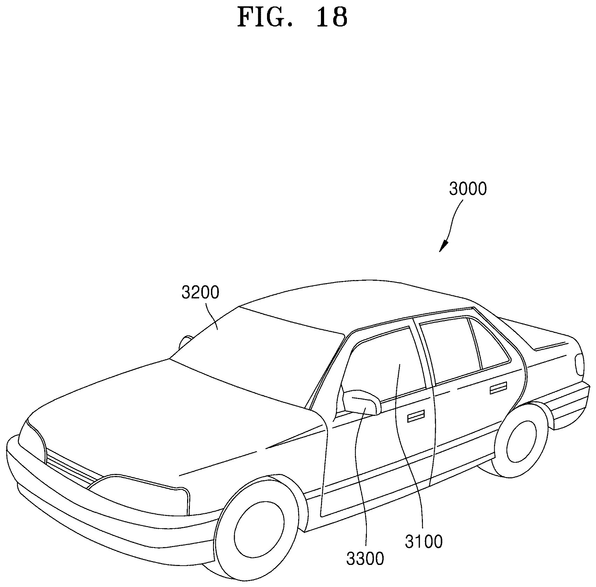

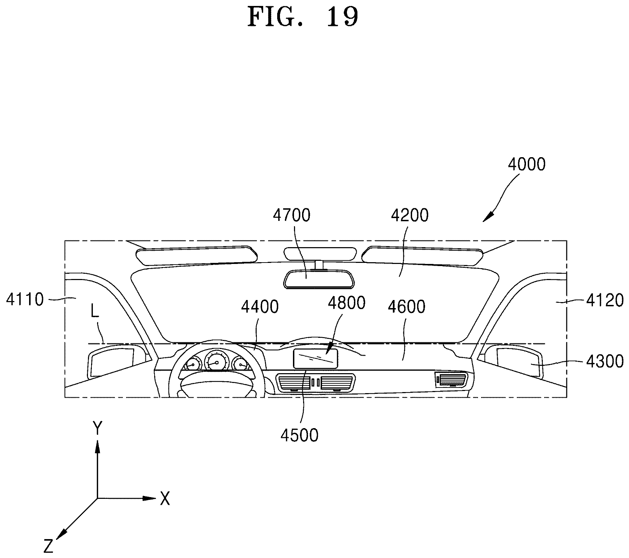

FIGS. 18 and 19 are views illustrating another electronic device to which a display device according to an embodiment is applied.

FIG. 18 is a view schematically illustrating the exterior of a transportation means 3000 to which a display device is applied as a particular example.

The transportation means 3000 may refer to various types of apparatuses for moving an object to be transported, such as a human, an object, or an animal, and may include a vehicle traveling on a road or a track, a ship moving over the sea or a river, an airplane flying through the sky using an action of air, and the like.

In some embodiments, the transportation means 3000 may also move in a certain direction according to rotation of at least one wheel. For example, the transportation means 3000 may include a three- or four-wheeled vehicle, a construction machine, a two-wheeled vehicle, a motor device, a bicycle, and a train traveling on a track.

The transportation means 3000 may include a body having an interior and an exterior, and a chassis on which mechanical devices needed for traveling are installed, which are remaining portions excluding the body. The exterior of the body may include fillers provided at boundaries among a front panel, a bonnet, a roof panel, a rear panel, a trunk, and doors.

The chassis of the transportation means 3000 may include a power generation device, a power transmission device, a traveling device, a steering device, a brake device, a suspension device, a gearbox, a fuel device, front, rear, left and right wheels, and the like.

The transportation means 3000 may include a side window glass 3100, a front window glass 3200, and a side mirror 3300.

The display device DD, DD-1, DD-2, DD-3, DD4, or DD-5, according to the embodiments described above, may be applied to one area of the transportation means 3000, e.g., any one of the side window glass 3100, the front window glass 3200, and the side mirror 3300. Through one of the side window glass 3100, the front window glass 3200, and the side mirror 3300, a user, e.g., a driver or a passenger of the transportation means 3000, may visually check information inside the transportation means 3000. In some embodiments, the user may perform a touch operation for an input such as checking desired information, and touch detection and information processing may be performed through a touch detection unit. Alternatively, the driver, the passenger, or outside passerbys may selectively check various types of information displayed on the transportation means 3000 even from the outside of a vehicle.

FIG. 19 is a view schematically illustrating the interior of a transportation means 4000 to which a display device is applied as a particular example.

The interior of the transportation means 4000 may include a cluster 4400, a center fascia 4500, and a passenger seat dashboard 4600.

In some embodiments, the transportation means 4000 may include side window glasses 4100, and the side window glasses 4100 may include a first side window glass 4110 and a second side window glass 4120.

In some embodiments, one or more side mirrors 4300 may be included in the transportation means 4000. The cluster 4400 may be located in front of a steering wheel. The cluster 4400 may include a tachometer, a speedometer, a coolant thermometer, a fuel gauge turn signal light, a high beam indicator light, a warning light, a seat belt warning light, a range meter, an odometer, an automatic transmission selector lever indicator light, a door open warning light, an engine oil warning light, and/or a low fuel warning light.

The center fascia 4500 may include an audio device, an air conditioner, and a control panel in which a plurality of buttons for adjusting heaters of seats are arranged. The center fascia 4500 may be arranged on one side of the cluster 4400.

The passenger seat dashboard 4600 may be arranged on one side of the center fascia 4500.

The display device DD, DD-1, DD-2, DD-3, DD-4, or DD-5, according to the embodiments described above, may be applied to one area of the transportation means 4000, e.g., one or more of the cluster 4400, the center fascia 4500, and the passenger seat dashboard 4600, and as an example, may be applied to a rear mirror portion 4700. Accordingly, a user, e.g., a driver or a passenger of the transportation means 4000, may visually check information through one or more of the cluster 4400, the center fascia 4500, the passenger seat dashboard 4600, and the rear mirror portion 4700 inside the transportation means 4000 perform a touch operation for an input such as checking information, and touch detection and information processing may be performed through a touch detection unit.

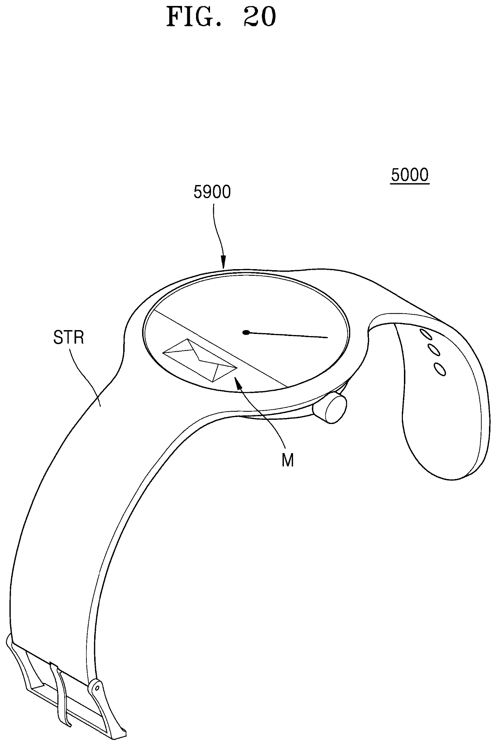

FIG. 20 is a view illustrating an electronic device to which a display device according to an embodiment is applied.

The display device described above, e.g., the display device DD, DD-1, DD-2, DD-3, DD-4, or DD-5, may be easily applied to various types of electronic devices, e.g., may be applied to an electronic device possessed or worn by a user, as a particular example, a wearable device.

Referring to FIG. 20, in an example of the disclosure, an electronic device may be a wearable electronic device 5000, and as a particular example, a smart watch.

The wearable electronic device 5000 may include a body 5900 and a stationary portion STR. The body 5900 may display an image M having certain information.

The image M may be implemented through the display device DD, DD-1, DD-2, DD-3, DD-4, or DD-5 described above, and may be, for example, implemented as light emitted from one or more light-emitting areas. In some embodiments, an area in which the image M is displayed may include an area for detecting a touch by a user, i.e., an area having arranged a touch detection unit in which a touch electrode is arranged. Accordingly, the user may check the image M of the body 5900 while wearing or carrying the wearable electronic device 5000 or perform an input operation through a direct touch by the user or a touch by a pen. In an embodiment, the body 5900 may include the display device 100 or 200 described above.

The image M may display an image implementing an existing analog clock, such as a clock hand indicating a current time, and an icon of an application running on an application processor or an execution screen of the application.

The body 5900 may be detachably coupled to the stationary portion STR. The user may wear the stationary portion STR on a wrist to use the wearable electronic device 5000 on the wrist. The stationary portion STR may have a strap shape, but the stationary portion STR is not necessarily limited to a purpose of being worn on the wrist of the user. The stationary portion STR may have a shape intended to be worn on an arm of the user or hung around on the neck, or may be replaced with a cradle for mounting the body 5900 to another electronic device.

According to an embodiment, a display device having an improved reflectivity and an electronic device including the same may be provided.

However, the effect is an example and the effect of the disclosure is not necessarily limited thereto.

The respective embodiments described above are embodiments that may be independently implemented, but structures of the respective embodiments may be complexly applied to other embodiments.

Although the disclosure has been described with reference to the embodiments illustrated in the drawings, the description is an example, and those skilled in the art will understand that various modifications and equivalent other embodiments may be made therefrom.

In the description of the embodiments (particularly, in claims), the use of the term "the" and similar indicative terms may correspond to both singular and plural forms. **In** addition, in the case where a range is described in the embodiments, it is considered to include the disclosure that applies individual values belonging to the range (unless otherwise stated), and is the same as describing the respective individual values constituting the range in the detailed description of the disclosure. Finally, in the case where there is no explicit description or contrary description of the order of operations constituting a method according to the embodiments, the operations may be performed in an appropriate order. The embodiments are not necessarily limited to the order in which the operations are described. The use of all examples or example terms in the embodiments is intended to illustrate the embodiments in detail and is not necessarily intended to limit the scope of the embodiments by the examples or example terms, unless otherwise limited by claims. In addition, those skilled in the art may appreciate that various modifications, combinations, and changes may be configured according to design conditions and factors within the scope of the appended claims or equivalents thereof.

## Claims

1. A display device (DD), comprising:
a display panel (DP) including a display area (DA);
an anti-reflection layer (RPL) disposed on the display panel (DP) and including a plurality of color filters (CF); and
an optical control module (OCM) comprising:
a first film layer (310) having a first optical axis corresponding to a stretching axis that extends in a first direction (DR1); and
a phase difference layer (320) disposed on the anti-reflection layer (RPL).

2. The display device (DD) of claim 1, wherein the phase difference layer (320) is disposed between the first film layer (310) and the anti-reflection layer (RPL).

3. The display device (DD) of any one of claims 1 or 2, wherein the first film layer (310) has a modulus in the first direction (DR1) and a modulus in a second direction (DR2) orthogonal to the first direction (DR1), wherein the modulus in the first direction (DR1) is greater than the modulus in the second direction (DR2).

4. The display device (DD) of claim 3, wherein a difference between the modulus in the first direction (DR1) and the modulus in the second direction (DR2) is within a range of from 0.5 Gpa to 3.0 GPa, inclusive.

5. The display device (DD) of any one of preceding claims, wherein the first film layer (310) has an average transmittance of visible light of at least 85%, and/or
wherein the first film layer (310) lacks a visible light absorption axis, and/or
wherein the first film layer (310) has an elongation ratio within a range from 1.5 times to 3 times, inclusive, and/or
wherein the first film layer (310) comprises polyethylene terephthalate, PET; polyvinyl alcohol, PVA; polycarbonate, PC; polymethyl methacrylate, PMMA; polystyrene, PS; polypropylene, PP; and/or triacetyl cellulose, TAC.

6. The display device (DD) of any one of preceding claims, wherein the phase difference layer (320) comprises a λ/4 phase retardation layer.

7. The display device (DD) of claim 6, wherein an angle between the first optical axis of the first film layer (310) and a second optical axis of the λ/4 phase retardation layer is 45 ± 5°.

8. The display device (DD) of any one of claims 6 or 7, wherein the phase difference layer (320) further comprises a λ/2 phase retardation layer.

9. The display device (DD) of claim 8, wherein an angle between a second optical axis of the λ/4 phase retardation layer and a third optical axis of the λ/2 phase retardation layer is 15 ± 5°.

10. The display device (DD) of any one of preceding claims, wherein the first film layer (310) comprises a first dye configured to selectively absorb light in a first preset wavelength band.

11. The display device (DD) of claim 10, wherein the first film layer (310) further comprises a second dye configured to selectively absorb light in a second preset wavelength band that is different from the first preset wavelength band.

12. The display device (DD) of any one of preceding claims, wherein the optical control module (OCM) further comprises a window layer, wherein the phase difference layer (320) is disposed under the window layer; and/or
wherein the optical control module (OCM) further comprises a second film layer that lacks an optical axis, and wherein the second film layer is disposed below the first film layer (310), and the phase difference layer (320) is disposed below the second film layer.

13. The display device (DD) of any one of preceding claims, wherein the optical control module (OCM) further comprises a surface treatment layer disposed on the first film layer (310), and
wherein the surface treatment layer comprises a hard coating layer.

14. The display device (DD) of claim 13, wherein the surface treatment layer further comprises a low refractive index layer, and/or a high refractive index layer disposed on the hard coating layer.

15. An electronic device (101), comprising:
an input module (1300) configured to receive a command or data;
a processor (1100) configured to process the command or data received from the input module (1300) and output image data or command data; and
a display device (1400, DD) according to any one of the preceding claims configured to implement one or more images by the processor (1100).
